# EUROPEAN PATENT APPLICATION

(11) **EP 4 661 625 A1**
(43) Date of publication of application: **10.12.2025**
(21) Application number: 25180948.9
(22) Date of filing: 05.06.2025
(51) Int. Cl.: H10D 86/40

(54) **DISPLAY DEVICE AND METHOD OF MANUFACTURING THE SAME**

(30) Priority: 05.06.2024 KR 20240073698
(71) Applicant: Samsung Display Co., Ltd., Gyeonggi-Do (KR)
(72) Inventor: Song, Seungho, Yongin-si, Gyeonggi-Do (KR); Kwon, Semyung, Yongin-si, Gyeonggi-Do (KR); Kim, Yeong-Gyu, Yongin-si, Gyeonggi-Do (KR); Bae, Injun, Yongin-si, Gyeonggi-Do (KR); Choi, Junwon, Yongin-si, Gyeonggi-Do (KR); Hwang, Young-In, Yongin-si, Gyeonggi-Do (KR)
(74) Representative: Gulde & Partner

(57) **Abstract**

A display device (DD) includes a base layer (BL), a pixel circuit (PXC) disposed on the base layer (BL) and comprising a plurality of pixel transistors (T1 to T6, T5a, T6a), a gate insulating layer (GL1, GL2) covering first and second oxide semiconductor patterns (SP1, SP2), and a light emitting element (ED) electrically connected to the pixel circuit (PXC). The plurality of pixel transistors (T1 to T6, T5a, T6a) include a first pixel transistor (T1) including the first oxide semiconductor pattern (SP1) and a second pixel transistor (T2) including the second oxide semiconductor pattern (SP2). An open area (OPA, OPAa) is defined through the gate insulating layer (GL1, GL2) to correspond to a first source (S1) and a first drain (D1) of the first oxide semiconductor pattern (SP1).

## Description

### BACKGROUND

### FIELD

The present disclosure relates to a display device and a method of manufacturing the same. More particularly, the present disclosure relates to a display device including an oxide transistor and a method of manufacturing the display device.

### DESCRIPTION OF RELATED ART

A display device typically includes a plurality of pixels and a driving circuit, e.g., a scan driving circuit and a data driving circuit, to control the pixels. Each of the pixels may include a display element and a pixel circuit to control the display element. The pixel circuit may include a plurality of transistors connected to each other, and the transistors may include a silicon semiconductor or a metal oxide semiconductor.

### SUMMARY

The present disclosure discloses a display device that may have improved reliability.

The present disclosure further discloses a method of manufacturing the display device.

An example embodiment in accordance with the present disclosure may provide a display device including a base layer, a pixel circuit disposed on the base layer and including a plurality of pixel transistors, wherein the plurality of pixel transistors include a first pixel transistor including a first oxide semiconductor pattern and a second pixel transistor including a second oxide semiconductor pattern, a gate insulating layer covering the first oxide semiconductor pattern and the second oxide semiconductor pattern (e.g., covering the plurality of pixel transistors), and a light emitting element electrically connected to the pixel circuit. An open area through the gate insulating layer may correspond to a first source and a first drain of the first oxide semiconductor pattern.

The display device may further include an insulating layer disposed on the gate insulating layer, and a first contact hole through the insulating layer may extend to a portion of the first source and a portion of the first drain.

The first contact hole may overlap the open area.

The display device may further include a first connection electrode disposed on the insulating layer and electrically connected to the first source, and may further include a second connection electrode disposed on the insulating layer and electrically connected to the first drain.

The first contact hole may include a first-first contact hole through which the first source is electrically connected to the first connection electrode, and may include a first-second contact hole through which the first drain is electrically connected to the second connection electrode.

The open area may include a first opened portion corresponding to the first source and may include a second opened portion corresponding to the first drain.

The first opened portion may have a width greater than a width of the first-first contact hole, and the second opened portion may have a width greater than a width of the first-second contact hole.

A width of the first opened portion may be equal to a width of the second opened portion.

The first opened portion may expose an edge of the first source, and the second opened portion may expose an edge of the first drain.

A second contact hole may extend through the gate insulating layer and the insulating layer to a portion of a second source and/or a portion of a second drain of the second oxide semiconductor pattern.

The display device may further include a third connection electrode disposed on the insulating layer and electrically connected to the second source, and may further include a fourth connection electrode disposed on the insulating layer and electrically connected to the second drain.

Each of the pixel transistors may include an oxide semiconductor.

The display device may further include a gate driving circuit disposed in a non-display area of the base layer and including a plurality of transistors, and at least one transistor among the transistors of the gate driving circuit may include a silicon semiconductor.

Each of the pixel transistors may be an N-type transistor, and each of the transistors of the gate driving circuit may be a P-type transistor.

The pixel transistors may further include a third pixel transistor, and the third pixel transistor may include a silicon semiconductor pattern.

The first pixel transistor may connect to the light emitting element at a first node, and the second pixel transistor may connect to the first pixel transistor at a second node.

The first pixel transistor may further include a first upper gate disposed on a first channel portion of the first oxide semiconductor pattern, and may further include a first lower gate disposed on the base layer and overlapping the first upper gate in a plan view, and the first lower gate may be electrically connected to the first source.

The gate insulating layer may further include a gate insulating pattern disposed between the first channel portion and the first upper gate and adjacent to the open area.

An embodiment in accordance with the present disclosure may provide a display device including a base layer, a first oxide semiconductor pattern disposed on the base layer and including a first region and a second region having a conductivity greater than a conductivity of the first region, a second oxide semiconductor pattern disposed on the base layer and spaced apart from the first oxide semiconductor pattern, and a gate insulating layer covering the first oxide semiconductor pattern and the second oxide semiconductor pattern and provided with an open area defined therethrough to correspond to the second region.

The display device may further include an insulating layer disposed on the gate insulating layer, and a first contact hole through the insulating layer may extend to a portion of the second region.

The first contact hole may overlap the open area.

The display device may further include first and second connection electrodes disposed on the insulating layer, and the second region may include a first source and a first drain, and the first and second connection electrodes may be electrically connected to the first source and the first drain, respectively.

The open area may include a first opened portion corresponding to the first source, and may include a second opened portion corresponding to the first drain.

The first opened portion may have a width that is equal to a width of the second opened portion.

A second contact hole may extend through the gate insulating layer and the insulating layer to a portion of a second source and/or a portion of a second drain of the second oxide semiconductor pattern.

The display device may further include a third connection electrode disposed on the insulating layer and electrically connected to the second source, and may further include a fourth connection electrode disposed on the insulating layer and electrically connected to the second drain.

An embodiments in accordance with the present disclosure may provide a method of manufacturing a display device. The method may include forming a first oxide semiconductor pattern and a second oxide semiconductor pattern on a base substrate, forming a gate insulating layer on the first oxide semiconductor pattern and the second oxide semiconductor pattern, first etching the gate insulating layer to form an open area through the gate insulating layer to a first source and a first drain of the first oxide semiconductor pattern, forming an insulating layer on the gate insulating layer, and second etching the insulating layer to form a first contact hole through the insulating layer and the gate insulating layer to a portion of the first source and a portion of the first drain.

The method may further include forming on the insulating layer a first connection electrode electrically connected to the first source and/or a second connection electrode electrically connected to the first drain.

The open area may include a first opened portion corresponding to the first source, and may include a second opened portion corresponding to the first drain, and each of the first and second opened portions may have a width greater than a width of the first contact hole.

The second etching may include etching the insulating layer and the gate insulating layer to form a second contact hole through which a portion of a second source and/or a portion of a second drain of the second oxide semiconductor pattern are exposed.

The method may further include forming, on the insulating layer, a third connection electrode electrically connected to the second source and/or a fourth connection electrode electrically connected to the second drain.

The open area may include a first opened portion corresponding to the first source, and may include a second opened portion corresponding to the first drain, and each of the first and second opened portions may have a width greater than a width of the second contact hole.

The method may further include forming a conductive pattern on the gate insulating layer before forming the open area, and the open area may be formed using the conductive pattern as a mask.

An edge of the first source and an edge of the first drain may be exposed through the open area.

The open area may be formed by a photolithography process.

The method further may include forming a silicon semiconductor pattern on the base substrate before the forming of the first oxide semiconductor pattern and the second oxide semiconductor pattern, and the silicon semiconductor pattern may be on a layer different from the first oxide semiconductor pattern and the second oxide semiconductor pattern.

An example embodiment in accordance with the present disclosure may provide an electronic device including a display device including a base layer, a pixel circuit disposed on the base layer and including a plurality of pixel transistors, a gate insulating layer covering the plurality of pixel transistors, and a light emitting element electrically connected to the pixel circuit. The pixel transistors may include a first pixel transistor including a first oxide semiconductor pattern and a second pixel transistor including a second oxide semiconductor pattern. An open area through the gate insulating layer may correspond to a first source and a first drain of the first oxide semiconductor pattern. According to the above, the open area may be formed to correspond to the source and the drain of at least one oxide semiconductor pattern among the oxide semiconductor patterns. When the source and the drain of the oxide semiconductor pattern are exposed through the open area, oxygen may be easily diffused into the channel portion. Thus, the ion concentration in a contact area of the first source and the first drain may be uniform, and the element characteristics of the transistor may be improved. Accordingly, screen characteristics and reliability of the display device may be improved.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other advantages of the present disclosure will become readily apparent by reference to the following detailed description when considered in conjunction with the accompanying drawings.
FIG. 1 is a perspective view of a display device according to an embodiment of the present disclosure.
FIGS. 2A and 2B are exploded perspective views of a display device according to an embodiment of the present disclosure.
FIG. 3 is a cross-sectional view of a display module according to an embodiment of the present disclosure.
FIG. 4 is a plan view of some components of a display module according to an embodiment of the present disclosure.
FIG. 5 is a block diagram of a display device according to an embodiment of the present disclosure.
FIG. 6A is a circuit diagram of a pixel according to an embodiment of the present disclosure.
FIG. 6B is a waveform diagram showing driving signals to drive the pixel shown in FIG. 6A.
FIG. 6C is a circuit diagram of a pixel according to an embodiment of the present disclosure.
FIG. 7A is a block diagram of first and second gate driving circuits according to an embodiment of the present disclosure.
FIG. 7B is a block diagram of a first write scan driving circuit according to an embodiment of the present disclosure.
FIG. 7C is a circuit diagram of a first stage in a scan driving circuit according to an embodiment of the present disclosure.
FIG. 8 is a cross-sectional view of a display panel according to an embodiment of the present disclosure.
FIG. 9A is an enlarged cross-sectional view of a first area shown in FIG. 8.
FIG. 9B is an enlarged cross-sectional view of a second area shown in FIG. 8.
FIG. 9C is an enlarged view of a portion of a display panel according to an embodiment of the present disclosure.
FIG. 10 is a cross-sectional view of a display panel according to an embodiment of the present disclosure,
FIGS. 11A, 11B, 11C, 11D, 11E, 11F, 11G, 11H, and 11I are views illustrating a manufacturing process of a display device in accordance with the embodiment of FIG. 10.

### DETAILED DESCRIPTION

The present disclosure may be modified and realized in many different ways, and thus only specific embodiments are exemplified in the drawings and described in detail hereinbelow. However, the present disclosure should not be limited to the specific forms disclosed but should be construed to include all modifications, equivalents, or replacements included in the scope of the present disclosure as defined by the appended claims.

In the present disclosure, an element (or area, layer, or portion) referred to as being "on", "connected to" or "coupled to" another element or layer may be directly on, connected or coupled to the other element or one or more intervening elements or layers may be present.

Like numerals refer to like elements throughout. In the drawings, the thicknesses, relative sizes or proportions, and dimensions of components may exaggerated or altered in the drawings for effective illustration of the technical content.

As used herein, the term "and/or" may include any and all combinations of one or more of the associated listed items.

The terms first, second, etc. may be used herein to describe various elements, bit these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe a relationship of one element or feature to another elements or features as shown in the figures.

Unless otherwise defined, all terms including technical and scientific terms used herein have the same meaning as commonly understood by one of ordinary skill in the art to which this disclosure belongs. Terms, such as those defined in commonly used dictionaries, should be interpreted as having a meaning that is consistent with their meaning in the context of the relevant art and should not be interpreted in an idealized or overly formal sense unless expressly so defined herein.

The terms "include" and/or "including", when used in this specification, specify the presence of stated features, integers, steps, operations, elements, and/or components, but do not preclude the presence or addition of one or more other features, integers, steps, operations, elements, components, and/or groups thereof.

Hereinafter, embodiments of the present disclosure are described with reference to accompanying drawings.

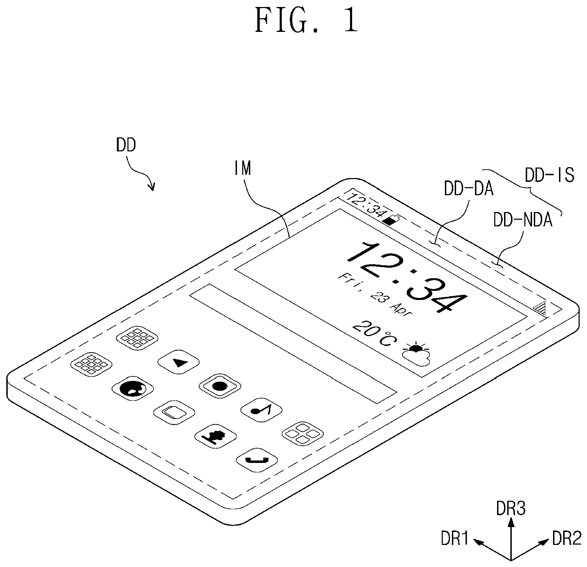

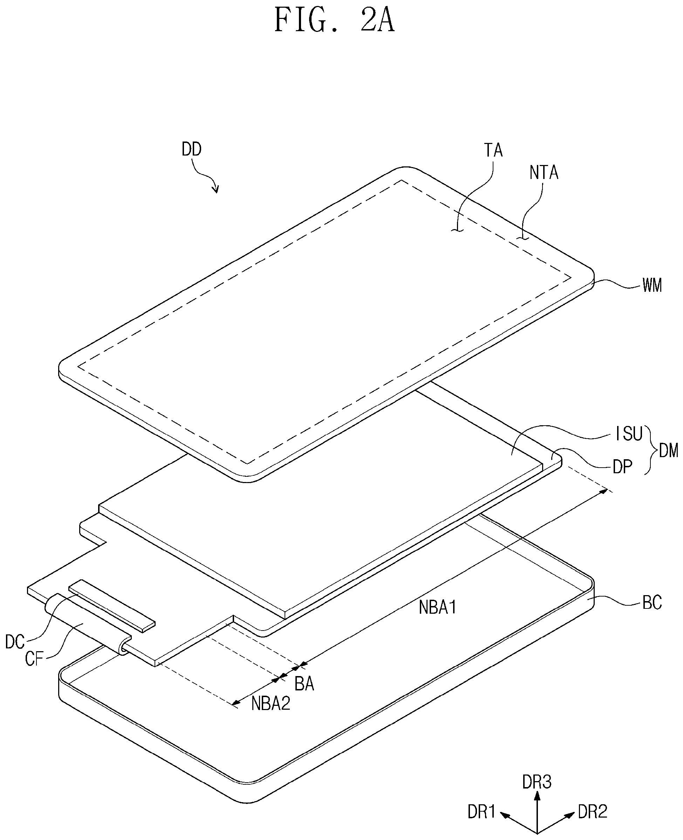

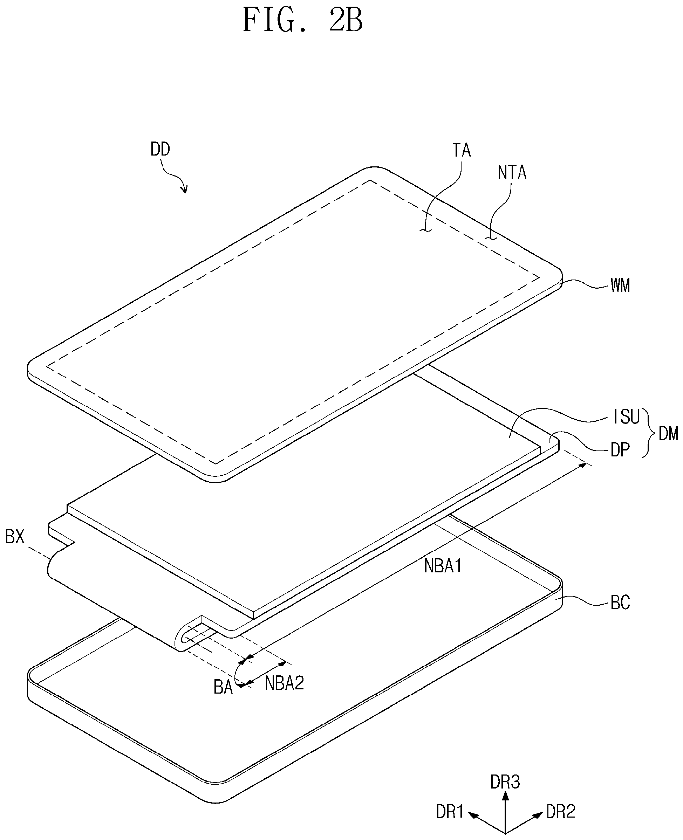

FIG. 1 is a perspective view of a display device DD according to an embodiment of the present disclosure. FIGS. 2A and 2B are exploded perspective views of the display device DD according to an embodiment of the present disclosure. FIG. 2A particularly shows the display device DD when a display panel DP has a flat state, and FIG. 2B shows a bent state of the display panel DP of the display device DD. In the present disclosure, a mobile phone terminal is shown as a representative example of the display device DD. The display device DD according to the present disclosure, however, may be applied to a large-sized electronic device, such as a television set and a monitor, and a small and medium-sized electronic device, such as a tablet computer, a car navigation unit, a game unit, and a smart watch.

Referring to FIG. 1, the display device DD may display an image IM through a display surface DD-IS. FIG. 1 shows application icons as a representative example of the image IM. The display surface DD-IS may be substantially parallel to a plane defined by a first direction DR1 and a second direction DR2. A normal line direction of the display surface DD-IS, i.e., a thickness direction of the display device DD, may be substantially parallel to a third direction DR3.

The display surface DD-IS may include a display area DD-DA through which the image IM is displayed and a non-display area DD-NDA adjacent to the display area DD-DA. The image IM may not be displayed through the non-display area DD-NDA. According to an embodiment, the non-display area DD-NDA may be omitted or may be adjacent to only one edge of the display area DD-DA.

In the present disclosure, the expression "in a plan view" may mean a state of being viewed along the third direction DR3. Front (or upper) and rear (or lower) surfaces of each layer or each unit of the display device DD described hereinafter may be distinguished from each other with respect to the third direction DR3. Combinations of the first, second, and third directions DR1, DR2, and DR3 may be changed to other combinations.

Referring to FIGS. 2A and 2B, the display device DD may include a window WM, a display module DM, and an accommodation member BC.

The window WM may be disposed on the display module DM, and an image form by the display module DM may be visible through the window WM. The window WM may include a transmission area TA and a non-transmission area NTA. The transmission area TA may overlap the display area DD-DA shown in FIG. 1 and may have a shape corresponding to that of the display area DD-DA. The window WM may include a base layer and one or more functional layers disposed on the base layer. The functional layers may include a protective layer, an anti-fingerprint layer, etc. The base layer of the window WM may include glass, sapphire, or plastic material. The base layer of the window WM may include an optically transparent insulating material. As an example, the base layer of the window WM may include a glass or plastic film. The base layer of the window WM may have a single-layer or multi-layer structure. As an example, the base layer of the window WM may include a plurality of plastic films coupled to each other by an adhesive or may include a glass substrate and a plastic film coupled to the glass substrate by an adhesive.

The non-transmission area NTA may overlap the non-display area DD-NDA and may have a shape corresponding to that of the non-display area DD-NDA. The non-transmission area NTA may have a relatively low light transmittance compared with that of the transmission area TA. A bezel pattern may be disposed in an area of the base layer of the window WM, the area in which the bezel pattern is disposed may be defined as the non-transmission area NTA, and an area of the base layer in which the bezel pattern is not disposed may be defined as the transmission area TA. However, the present disclosure should not be limited thereto or thereby, and the non-transmission area NTA may be omitted.

Although not shown in figures, an anti-reflective layer may be further disposed between the window WM and the display module DM. The anti-reflective layer may reduce a reflectance of an external light incident thereto from the outside of the display device DD. The anti-reflective layer may include color filters. The color filters may be arranged in a predetermined arrangement. As an example, the color filters may be arranged according to the colors of lights emitted from pixels included in the display panel DP. In addition, the anti-reflective layer may further include a black matrix adjacent to the color filters.

The display module DM may include the display panel DP and an input sensor ISU.

The display panel DP may be one of a liquid crystal display panel, an electrophoretic display panel, a microelectromechanical system (MEMS) display panel, an electrowetting display panel, an organic light emitting display panel, an inorganic light emitting display panel, and a quantum dot light emitting display panel, and it should not particularly limited. Hereinafter, the organic light emitting display panel is described as an example of the display panel DP.

The input sensor ISU may include one of a capacitive sensor, an optical sensor, an ultrasonic sensor, and an electromagnetic induction sensor. The input sensor ISU may be formed on the display panel DP through successive processes or may be attached to an upper portion of the display panel DP using an adhesive layer after being separately manufactured.

The display module DM may include a printed circuit board CF and a driving chip DC. Although not shown in figures, a main circuit board may be disposed at one side of the printed circuit board CF. The printed circuit board CF may electrically connect the display panel DP and the main circuit board. FIG. 2A shows a structure in which the driving chip DC is mounted on the display panel DP, however, the present disclosure should not be limited thereto or thereby. The driving chip DC may, in response to a control signal provided from the printed circuit board CF, may generate a driving signal required to operate the display panel DP.

The display panel DP may include a bending area BA, a first non-bending area NBA1, and a second non-bending area NBA2 spaced apart the first non-bending area NBA1 with the bending area BA interposed therebetween in the second direction DR2.

The bending area BA may be a portion of the display panel DP, which is bent with respect to a bending axis BX extending in the first direction DR1. The first non-bending area NBA1 may overlap the transmission area TA, and the second non-bending area NBA2 may be an area to which the printed circuit board CF is connected. When the bending area BA of the display panel DP is bent with respect to the bending axis BX, the printed circuit board CF and the driving chip DC may be disposed under the display panel DP. Although not shown in figures, the display device DD or the display panel DP in particular may include additional components to compensate for a step difference caused by the bending area BA between the printed circuit board CF and the rear surface of the display panel DP.

According to an embodiment, a width in the second direction DR2 of the first non-bending area NBA1 may be greater than a width in the second direction DR2 of the bending area BA and the second non-bending area NBA2, however, the present disclosure should not be limited thereto or thereby. According to an embodiment, the width in the second direction DR2 of the bending area BA may gradually decrease from the first non-bending area NBA1 to the second non-bending area NBA2, however, the bending area BA is not be limited thereto or thereby.

As shown in FIG. 2B, when the display panel DP is bent, the printed circuit board CF electrically bonded to the display panel DP may be disposed on the rear surface of the display panel DP.

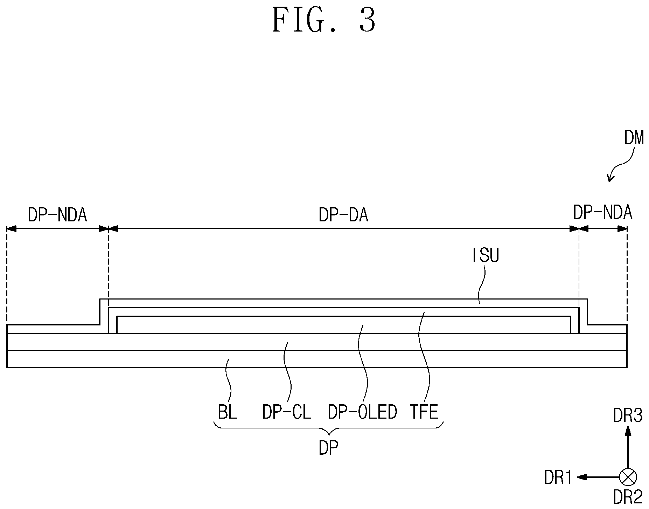

The accommodation member BC may be a housing that accommodates the display module DM and may be coupled to the window WM. The printed circuit board CF may be disposed at one end of the display panel DP and may be electrically connected to a circuit element layer DP-CL (refer to FIG. 3). Although not shown in figures, the display device DD may further include a main board, electronic modules, a camera module, a power module, or the like, and the electronic modules, the camera module, and the power module may be mounted on the main board.

In the illustrated embodiment, the mobile phone terminal is described as a representative example of the display device DD, however, the display device DD may include two or more electronic parts electrically bonded to each other. The display panel DP and the driving chip DC mounted on the display panel DP may correspond to different electronic parts, and the display device DD may be configured to include only the display panel DP and the driving chip DC, and the display panel DP is not limited to the illustrated embodiment.

According to an embodiment, the display device DD may include the display panel DP with only the printed circuit board CF connected to the display panel DP, or the display device DD may include only the main board with the display module DM mounted on the main board. Hereinafter, descriptions of the display device DD focus on a bonding structure between the display panel DP and the driving chip DC mounted on the display panel DP.

FIG. 3 is a cross-sectional view of the display module DM according to an embodiment of the present disclosure.

Referring to FIG. 3, the display panel DP may include a base layer BL with the circuit element layer DP-CL, a display element layer DP-OLED, and an encapsulation layer TFE sequentially stacked on the base layer BL. The input sensor ISU may be disposed on the encapsulation layer TFE.

The display panel DP may include a display area DP-DA and a non-display area DP-NDA. The display area DP-DA of the display panel DP may correspond to the display area DD-DA shown in FIG. 1 or the transmission area TA shown in FIG. 2A, and the non-display area DP-NDA may correspond to the non-display area DD-NDA shown in FIG. 1 or the non-transmission area NTA shown in FIG. 2A.

The base layer BL may include at least one plastic film. The base layer BL may be a flexible substrate and may include a plastic substrate, a glass substrate, a metal substrate, or an organic/inorganic composite material substrate.

The circuit element layer DP-CL may include circuit elements and at least one intermediate insulating layer. The intermediate insulating layer may include at least one intermediate inorganic layer and at least one intermediate organic layer. The circuit elements may include signal lines and a pixel driving circuit.

The display element layer DP-OLED may include a plurality of light-emitting elements such as organic light emitting diodes. The display element layer DP-OLED may further include an organic layer such as a pixel definition layer.

The encapsulation layer TFE may encapsulate the display element layer DP-OLED. The encapsulation layer TFE may be disposed on the display element layer DP-OLED. The encapsulation layer TFE may overlap the display area DP-DA and the non-display area DP-NDA. The encapsulation layer TFE may overlap at least a portion of the non-display area DP-NDA. As an example, the encapsulation layer TFE may include a thin film encapsulation layer. The thin film encapsulation layer may have a stack structure such as an inorganic layer/organic layer/inorganic layer structure. The encapsulation layer TFE may protect the display element layer DP-OLED from moisture, oxygen, and foreign substances such as dust particles, however, the encapsulation layer TFE is not limited thereto or thereby. According to an embodiment, the encapsulation layer TFE may further include an additional insulating layer in addition to the thin film encapsulation layer. For instance, the encapsulation layer TFE may further include an optical insulating layer to control a refractive index at a surface of the encapsulation layer TFE.

According to an embodiment, a sealing substrate may be provided instead of the encapsulation layer TFE. In this case, the sealing substrate may face the base layer BL, and the circuit element layer DP-CL and the display element layer DP-OLED may be disposed between the sealing substrate and the base layer BL.

The input sensor ISU may be disposed directly on the display panel DP. In the present disclosure, the expression "A component A is disposed directly on a component B" means that no intervening elements are present between the component A and the component B. In the embodiment of FIG. 3, the input sensor ISU may be formed through successive processes on the display panel DP, however, the present disclosure should not be limited thereto or thereby. According to an embodiment, the input sensor ISU may be fabricated as a separate panel and then may be coupled to the display panel DP, e.g., using an adhesive layer. According to an embodiment, the input sensor ISU may be omitted.

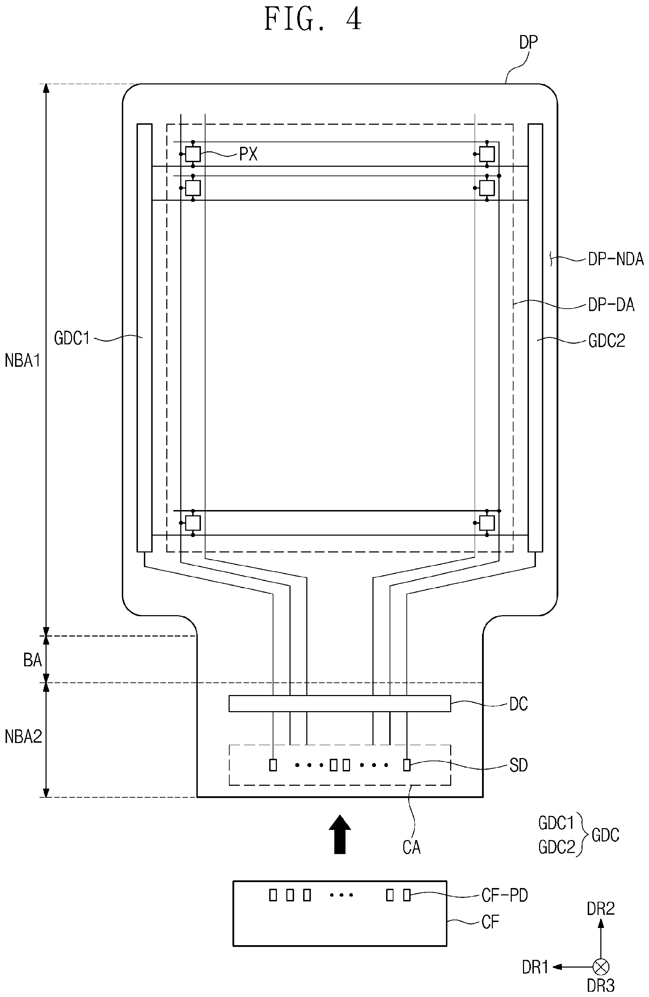

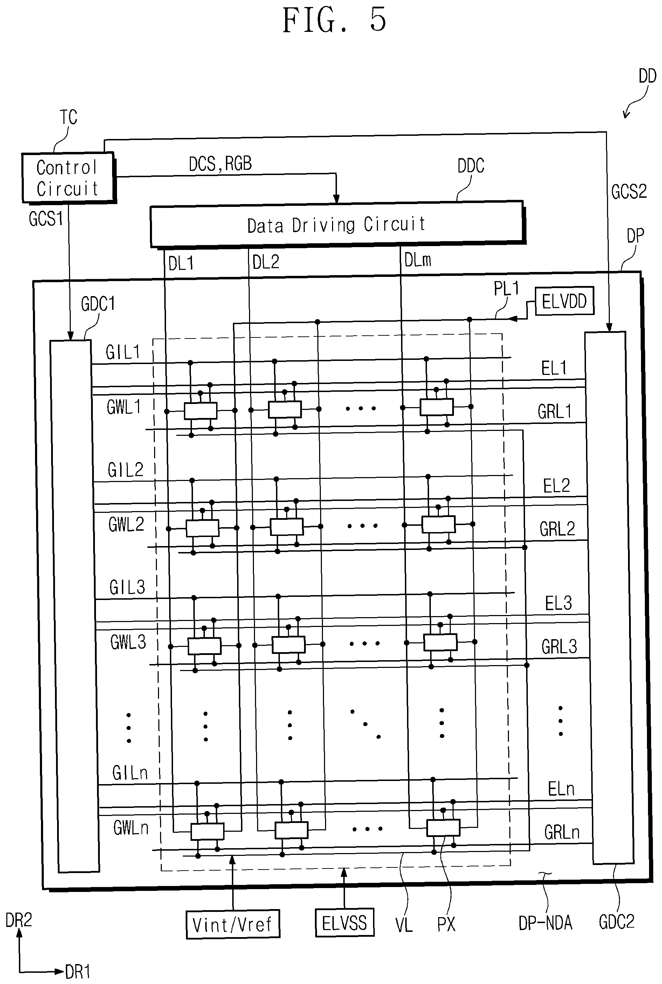

FIG. 4 is a plan view of some components of the display module according to an embodiment of the present disclosure. FIG. 5 is a block diagram of the display device DD according to an embodiment of the present disclosure.

Referring to FIG. 4, the display panel DP may include a plurality of pixels PX, a gate driving circuit GDC, and a plurality of display pads SD. The pixels PX may be arranged in the display area DP-DA. Each of the pixels PX may include an organic light emitting diode and a pixel driving circuit connected to the organic light emitting diode. The gate driving circuit GDC may be included in the circuit element layer DP-CL shown in FIG. 3.

The gate driving circuit GDC may be disposed in the non-display area DP-NDA and may drive the pixels PX that are in the display area DP-DA. As an example, the gate driving circuit GDC may include a first gate driving circuit GDC1 disposed in the non-display area DP-NDA adjacent to a first side of the display area DP-DA and a second gate driving circuit GDC2 disposed in the non-display area DP-NDA adjacent to a second side of the display area DP-DA. The first and second gate driving circuits GDC1 and GDC2 may sequentially output gate signals to a plurality of gate lines. The first and second gate driving circuits GDC1 and GDC2 may include a plurality of transistors formed through the same process, for instance, a low temperature polycrystalline silicon (LTPS) process or a low temperature polycrystalline oxide (LTPO) process, that forms the pixel driving circuits of the pixels PX. The display panel DP may further include another driving circuit (not shown) to apply an emission control signal to the pixels PX.

The display panel DP may include the display pads SD. The display pads SD may be arranged to be spaced apart from each other by a predetermined distance in the first direction DR1. The display pads SD may be arranged to overlap the second non-bending area NBA2. The display pads SD may be disposed in a contact area CA of the second non-bending area NBA2. The contact area CA of the second non-bending area NBA2 may be an area in which the display pads SD are arranged, and the printed circuit board CF may be attached to the contact area CA.

The display pads SD may overlap the contact area CA. The driving chip DC may be mounted on the display panel DP in the second non-bending area NBA2. The display pads SD may be electrically connected to the driving chip DC and may transmit electrical signals applied thereto from the driving chip DC to signal lines.

The printed circuit board CF may include substrate pads CF-PD electrically connected to the display panel DP. The substrate pads CF-PD may be arranged to be spaced apart from each other by a predetermined distance in the first direction DR1.

The display pads SD may be electrically connected to the substrate pads CF-PD included in the printed circuit board CF to transmit electrical signals applied thereto from the printed circuit board CF to the display panel DP.

The printed circuit board CF may be rigid or flexible. The printed circuit board CF may include a control circuit TC (refer to FIG. 5) to control an operation of the display panel DP. Although not shown in figures, the control circuit TC may be mounted on the printed circuit board CF in the form of an integrated circuit chip. In addition, although not shown in figures, the printed circuit board CF may include an input sensing circuit to control the input sensor ISU (refer to FIG. 2A).

Referring to FIGS. 4 and 5, the display device DD may include the display panel DP, the first and second gate driving circuits GDC1 and GDC2, a data driving circuit DDC, and the control circuit TC.

The control circuit TC may control the first and second gate driving circuits GDC1 and GDC2 and the data driving circuit DDC. The control circuit TC may convert a data format of input image signals to image data RGB having a data format appropriate to an interface between the control circuit TC and the data driving circuit DDC. The control circuit TC may output the image data RGB and various control signals DCS, GCS1, and GCS2.

The first gate driving circuit GDC1 may receive a first gate control signal GCS1 from the control circuit TC, and the second gate driving circuit GDC2 may receive a second gate control signal GCS2 from the control circuit TC. The first gate control signal GCS1 may include a start signal that starts an operation of the first gate driving circuit GDC1 and a clock signal that determines an output timing of signals, and the second gate control signal GCS2 may include a start signal that starts an operation of the second gate driving circuit GDC2 and a clock signal that determines an output timing of signals. The first and second gate driving circuits GDC1 and GDC2 may output the scan signals to a plurality of scan lines GWL1 to GWLn, GRL1 to GRLn, and GIL1 to GILn, which are described further below. Among the scan lines GWL1 to GWLn, GRL1 to GRLn, and GIL1 to GILn, a first group of scan lines GWL1 to GWLn may be referred to as write scan lines. Among the scan lines GWL1 to GWLn, GRL1 to GRLn, and GIL1 to GILn, a second group of scan lines GRL1 to GRLn may be referred to as reference scan lines. Among the scan lines GWL1 to GWLn, GRL1 to GRLn, and GIL1 to GILn, a third group of scan lines GIL1 to GILn may be referred to as initialization scan lines.

In addition, at least one of the first and second gate driving circuits GDC1 and GDC2 may generate a plurality of emission control signals and may output the emission control signals to emission signal lines EL1 to ELn.

The data driving circuit DDC may receive a data control signal DCS and the image data RGB from the control circuit TC. The data driving circuit DDC may convert the image data RGB to data signals and may output the data signals to a plurality of data lines DL1 to DLm described further below. The data signals may be analog voltages corresponding to grayscale values indicated by the image data RGB. The data driving circuit DDC may be included in the driving chip DC shown in FIG. 2A.

The display panel DP may include the scan lines GWL1 to GWLn, GRL1 to GRLn, and GIL1 to GILn, the emission signal lines EL1 to ELn, the data lines DL1 to DLm, and the pixels PX. The scan lines GWL1 to GWLn, GRL1 to GRLn, and GIL1 to GILn may extend in the first direction DR1 and may be distributed along the second direction DR2 perpendicular to the first direction DR1. Each of the emission signal lines EL1 to ELn may be parallel to a corresponding scan line among the scan lines GWL1 to GWLn, GRL1 to GRLn, and GIL1 to GILn. The data lines DL1 to DLm may be insulated from the scan lines GWL1 to GWLn, GRL1 to GRLn, and GIL1 to GILn where the data lines DL1 to DLm cross the scan lines GWL1 to GWLn, GRL1 to GRLn, and GIL1 to GILn.

Each of the pixels PX may be connected to a corresponding scan line among the scan lines GWL1 to GWLn, a corresponding scan line among the scan lines GRL1 to GRLn, and a corresponding scan line among the scan lines GIL1 to GILn, a corresponding emission signal line among the emission signal lines EL1 to ELn, and a corresponding data line among the data lines DL1 to DLm.

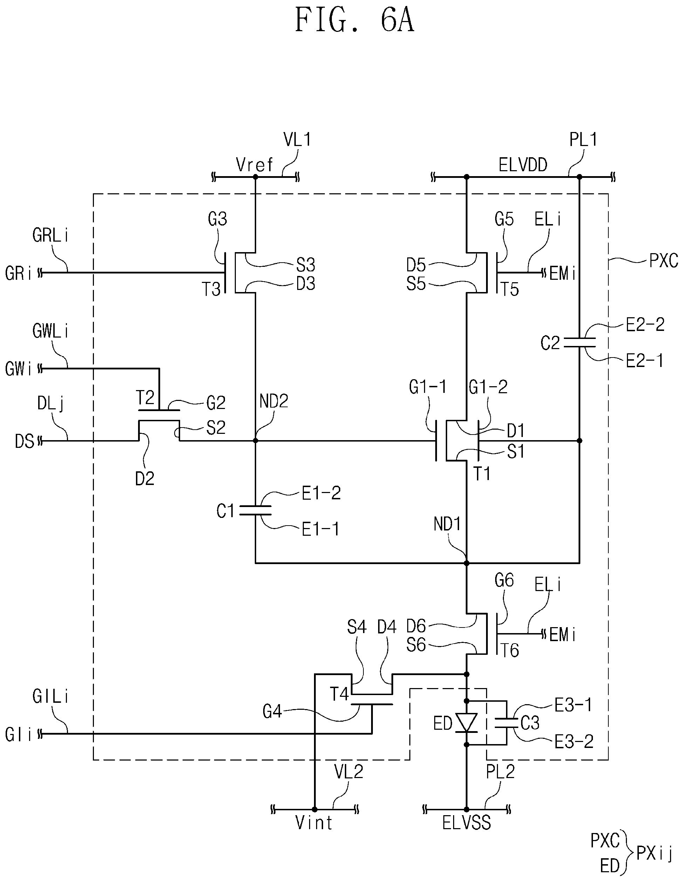

The display panel DP may receive a first power supply voltage ELVDD and a second power supply voltage ELVSS. The first power supply voltage ELVDD may be applied to the pixels PX through a first power line PL1. The second power supply voltage ELVSS may be applied to the pixels PX through a second power line PL2 (refer to FIG. 6A) formed in the display panel DP.

The display panel DP may further receive an initialization voltage Vint and a reference voltage Vref. The initialization voltage Vint and the reference voltage Vref may be applied to the pixels PX through a voltage line VL.

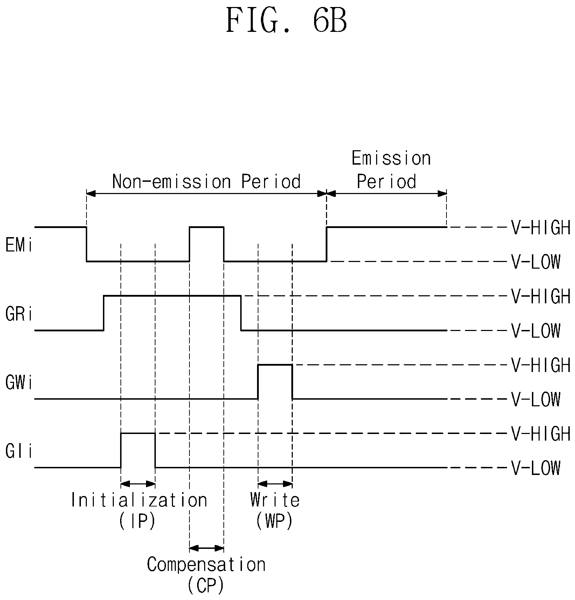

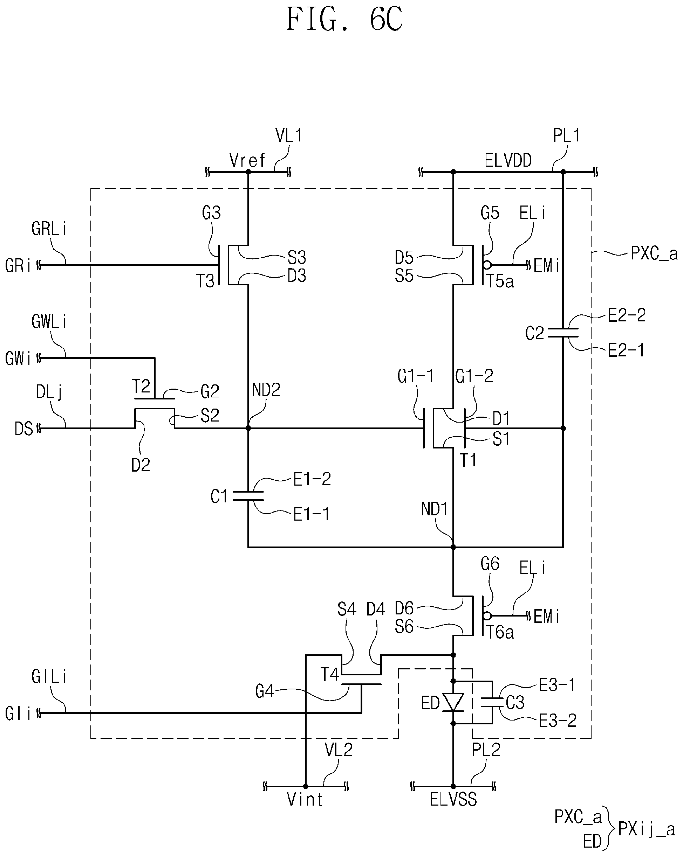

FIG. 6A is a circuit diagram of a pixel PXij according to an embodiment of the present disclosure. FIG. 6B is a waveform diagram of driving signals applied to the pixel PXij shown in FIG. 6A. FIG. 6C is a circuit diagram of a pixel PXij_a according to an embodiment of the present disclosure. Reference numerals in FIG. 6C that are the same as reference numerals in Fig. 6A denote the same elements as in FIG. 6A, and redundant descriptions of elements shown in FIG. 6C that are the same as elements shown in FIG. 6A may be omitted.

FIG. 6A shows the pixel PXij connected to an i-th write scan line GWLi among the write scan lines GWL1 to GWLn (refer to FIG. 5) and a j-th data line DLj among the data lines DL1 to DLm (refer to FIG. 5). The pixel PXij may be connected to an i-th reference scan line GRLi among the reference scan lines GRL1 to GRLn (refer to FIG. 5) and an i-th initialization scan line GILi among the initialization scan lines GIL1 to GILn (refer to FIG. 5).

The pixel PXij may include a pixel circuit (or a pixel driving circuit) PXC and a light emitting element ED electrically connected to the pixel circuit PXC. In the present embodiment, the pixel circuit PXC may include six transistors (hereinafter, referred to as first, second, third, fourth, fifth, and sixth pixel transistors T1 to T6) and three capacitors (hereinafter, referred to as a first capacitor C1, a second capacitor C2, and a third capacitor C3). In an embodiment, the first to sixth pixel transistors T1 to T6 may include an oxide semiconductor. Each of the first to sixth pixel transistors T1 to T6 may be a first type, e.g., an N-type, transistor. According to an embodiment, at least one of the first to sixth pixel transistors T1 to T6 may be omitted from the pixel PXij, or an additional pixel transistor may be added to the pixel PXij.

In the present embodiment, the first pixel transistor T1 may include two gates, e.g., an upper gate and a lower gate, however, according to an embodiment, the first pixel transistor T1 may include only one gate. In the present embodiment, the first pixel transistor T1 may be referred to as a driving transistor, and the second pixel transistor T2 may be referred to as a switching transistor. A node at which the first pixel transistor T1 is connected to the sixth pixel transistor T6 may be referred to as a first node ND1, and a node at which the first pixel transistor T1 is connected to the second pixel transistor T2 may be referred to as a second node ND2. In an embodiment, the sixth pixel transistor T6 may be omitted, and the first pixel transistor T1 may be connected to the light emitting element ED at the first node ND1.

The light emitting element ED may include a first electrode electrically connected to a source S6 of the sixth pixel transistor T6, a second electrode connected to the second power line PL2 receiving the second power supply voltage ELVSS, and a light emitting layer disposed between the first electrode and the second electrode. The light emitting element ED is described further below.

The first pixel transistor T1 may be electrically connected between the first power line PL1 receiving the first power supply voltage ELVDD and the first node ND1. The first pixel transistor T1 may include a source S1 (hereinafter, referred to as a first source) connected to the first node ND1, a drain D1 (hereinafter, referred to as a first drain), a semiconductor region, and an upper gate G1-1 (hereinafter, referred to as a first upper gate) electrically connected to the second node ND2. The first pixel transistor T1 may further include a lower gate G1-2 (hereinafter, referred to as a first lower gate) connected to the first node ND1.

The second pixel transistor T2 may be electrically connected between the j-th data line DLj and the second node ND2. The second pixel transistor T2 may include a source S2 (hereinafter, referred to as a second source) connected to the second node ND2, a drain D2 (hereinafter, referred to as a second drain) connected to the j-th data line DLj, a semiconductor region, and a second upper gate G2 connected to the i-th write scan line GWLi. Although not shown in figures, the second pixel transistor T2 may further include a gate (or a second lower gate) electrically connected to the second upper gate G2.

The third pixel transistor T3 may be electrically connected between the second node ND2 and the first voltage line VL1 receiving the reference voltage Vref. The third pixel transistor T3 may include a drain D3 (hereinafter, referred to as a third drain) connected to the second node ND2, a source S3 (hereinafter, referred to as a third source) connected to the first voltage line VL1, a semiconductor region, and a gate G3 (or a third upper gate) connected to the i-th reference scan line GRLi. The third pixel transistor T3 may further include a gate (or a third lower gate) electrically connected to the third upper gate G3.

The fourth pixel transistor T4 may be electrically connected between the second voltage line VL2 receiving the initialization voltage Vint and the light emitting element ED. The fourth pixel transistor T4 may include a drain D4 (hereinafter, referred to as a fourth drain) connected to the first electrode of the light emitting element ED, a source S4 (hereinafter, referred to as a fourth source) connected to the second voltage line VL2, a semiconductor region, and a gate G4 (or a fourth upper gate) connected to the i-th initialization scan line GILi. The fourth pixel transistor T4 may further include a gate (or a fourth lower gate) electrically connected to the fourth upper gate G4.

The fifth pixel transistor T5 may be electrically connected between the first power line PL1 and the first drain D1. In the present embodiment, the fifth pixel transistor T5 may include a drain D5 (hereinafter, referred to as a fifth drain) connected to the first power line PL1, a source S5 (hereinafter, referred to as a fifth source) connected to the first drain D1, a semiconductor region, and a gate G5 (or a fifth upper gate) connected to an i-th emission signal line ELi. The fifth pixel transistor T5 may further include a gate (or a fifth lower gate) electrically connected to the fifth upper gate G5.

The sixth pixel transistor T6 may be electrically connected between the first node ND1 and the light emitting element ED. In the present embodiment, the sixth pixel transistor T6 may include a drain D6 (hereinafter, referred to as a sixth drain) connected to the first node ND1, a source S6 (hereinafter, referred to as a sixth source) connected to the first electrode of the light emitting element ED, a semiconductor region, and a gate G6 (or a sixth upper gate) connected to the i-th emission signal line ELi. The sixth pixel transistor T6 may further include a gate (or a sixth lower gate) electrically connected to the sixth upper gate G6. According to an embodiment, the sixth pixel transistor T6 may be omitted. In this case, the first pixel transistor T1 may be connected to the light emitting element ED at the first node ND1.

The first capacitor C1 may be electrically connected between the first node ND1 and the second node ND2. The first capacitor C1 may include a first electrode E1-1 connected to the first node ND1 and a second electrode E1-2 connected to the second node ND2.

The second capacitor C2 may be electrically connected between the first power line PL1 and the first node ND1. The second capacitor C2 may include a first electrode E2-1 connected to the first node ND1 and a second electrode E2-2 connected to the first power line PL1.

The third capacitor C3 may be electrically connected between the first electrode and the second electrode of the light emitting element ED. The third capacitor C3 may include a first electrode E3-1 connected to the first electrode of the light emitting element ED and a second electrode E3-2 connected to the second electrode of the light emitting element ED.

Hereinafter, the operation of the pixel PXij will be described in detail with reference to FIGS. 6A and 6B. FIG. 6B shows signals EMi, GRi, GWi, and Gli that may be applied to the pixel PXij of FIG. 6A during a non-emission period and an emission period, which may be portions of a frame period. The display device DD (refer to FIG. 1) may display an image every frame period. Each of the write scan lines, the reference scan lines, the initialization scan lines, and the emission signal lines may sequentially receive the scan signals or the emission control signals for the frame period.

Referring to FIGS. 6A and 6B, each of scan signals EMi, GRi, GWi, and Gli may have a high voltage V-HIGH (or a high level) for some periods and may have a low voltage V-LOW (or a low level) for some periods. The N-type first to sixth pixel transistors T1 to T6 described above may be turned on when a corresponding scan signal has the high voltage V-HIGH.

During an initialization period IP of the non-emission period, the third pixel transistor T3 and the fourth pixel transistor T4 may be turned on. During the initialization period IP, the second node ND2 may be initialized to the reference voltage Vref, through the turned-on third pixel transistor T3, and the first electrode of the light emitting element ED may be initialized to the initialization voltage Vint through the turned-on fourth pixel transistor T4. The first capacitor C1 may be initialized to a difference between the reference voltage Vref and the initialization voltage Vint. The second capacitor C2 may be initialized to a difference between the first power supply voltage ELVDD and the initialization voltage Vint. The third capacitor C3 may be initialized to a difference between the second power supply voltage ELVSS and the initialization voltage Vint.

During a compensation period CP, the third pixel transistor T3, the fifth pixel transistor T5, and the sixth pixel transistor T6 may be turned on. A threshold voltage of the first pixel transistor T1 may be compensated for by a coupling of the first capacitor C1. That is, a voltage difference then stored across the first capacitor C1 may equal the threshold voltage of the first pixel transistor T1.

During a write period WP, the second pixel transistor T2 may be turned on. The second pixel transistor T2 may output a voltage corresponding to the data signal DS. Consequently, the first capacitor C1 may be charged or boosted according to a voltage corresponding to the data signal DS. The first capacitor C1 may be charged with the data signal DS in which the threshold voltage of the first pixel transistor T1 is compensated. The threshold voltage of the first pixel transistors T1 may be different for each pixel PX (refer to FIG. 4), but the pixel PXij shown in FIG. 6A may supply a current proportional to the data signal DS to the light emitting element ED regardless of the difference in threshold voltage of the first pixel transistors T1.

Then, the fifth pixel transistor T5 and the sixth pixel transistor T6 may be substantially simultaneously turned on during the emission period. The current output through the first pixel transistor T1 may be supplied to the light emitting element ED through the turned-on sixth pixel transistor T6. Accordingly, the light emitting element ED may emit a light with brightness corresponding to the current.

Referring to FIG. 6C, an embodiment of the pixel PXij_a may include a pixel circuit PXC_a electrically connected to light emitting element ED. In this embodiment, each of a fifth pixel transistor T5a and a sixth pixel transistors T6a may include silicon semiconductor, e.g., low temperature polysilicon (LTPS) semiconductor. Each of the fifth pixel transistor T5a and the sixth pixel transistor T6a may be a second type transistor, e.g., a P-type transistor, however, the present disclosure is not limited thereto or thereby. According to an embodiment, a first pixel transistor T1 and a second pixel transistors T2 may include an oxide semiconductor, and each of third, fourth, fifth, and sixth pixel transistors T3, T4, T5a, and T6a may include a silicon semiconductor.

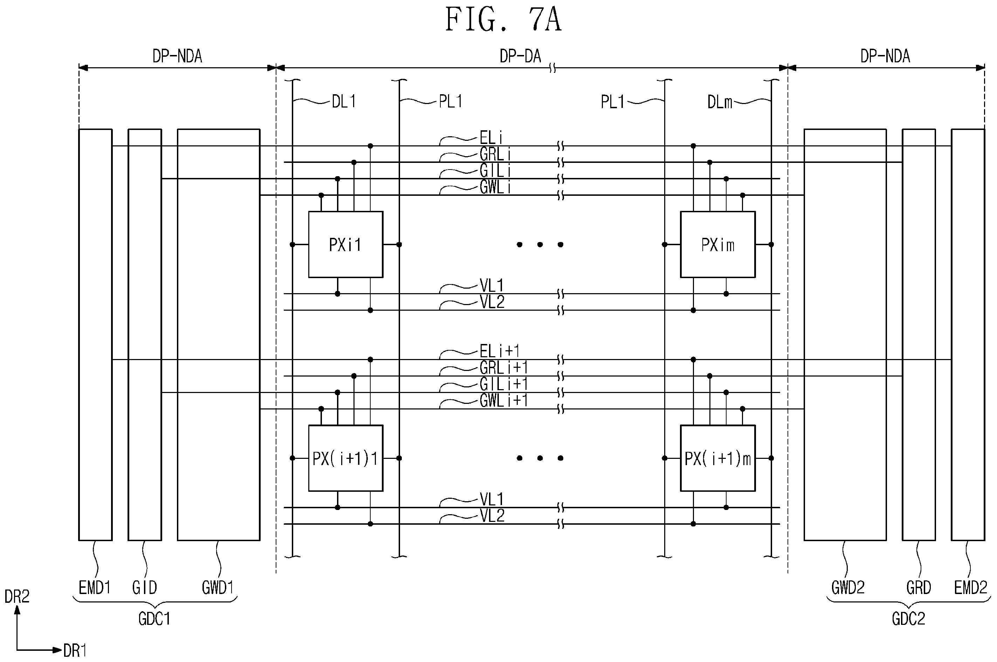

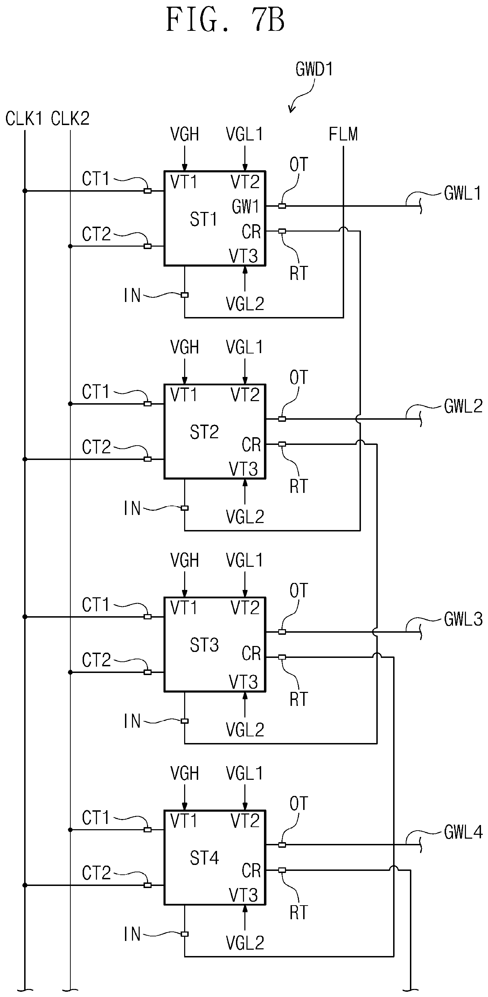

FIG. 7A is a block diagram showing the first and second gate driving circuits GDC1 and GDC2 according to an embodiment of the present disclosure. FIG. 7B is a block diagram of a first write scan driving circuit GWD1 according to an embodiment of the present disclosure.

Referring to FIG. 7A, the first gate driving circuit GDC1 and the second gate driving circuit GDC2 may be disposed in the non-display area DP-NDA (refer to FIG. 3) of the display panel DP. The first gate driving circuit GDC1 may be disposed adjacent to the first side, e.g., a left side with respect to the display area DP-DA (refer to FIG. 3), and the second gate driving circuit GDC2 may be disposed adjacent to the second side, e.g., a right side with respect to the display area DP-DA.

The first gate driving circuit GDC1 may include a first emission control circuit EMD1, the first write scan driving circuit GWD1, and an initialization scan driving circuit GID. The second gate driving circuit GDC2 may include a second emission control circuit EMD2, a second write scan driving circuit GWD2, and a reference scan driving circuit GRD. An arrangement order of the first emission control circuit EMD1, the first write scan driving circuit GWD1, and the initialization scan driving circuit GID shown in FIG. 7A along the first direction DR1 and an arrangement order of the second emission control circuit EMD2, the second write scan driving circuit GWD2, and the reference scan driving circuit GRD shown in FIG. 7A along the first direction DR1 are merely examples, and embodiments of the present disclosure are not limited to the arrangement illustrated in FIG. 7A.

The first and second emission control circuits EMD1 and EMD2 may be connected to the emission signal lines EL1 to ELn (refer to FIG. 5), and FIG. 7A shows the i-th emission signal line ELi and an (i+1)th emission signal line ELi+1 as a representative example. FIG. 7A shows the i-th write scan line GWLi and an (i+1)th write scan line GWLi+1 connected to the first and second write scan driving circuits GWD1 and GWD2 as a representative example. FIG. 7A shows the i-th reference scan line GRLi and an (i+1)th reference scan line GRLi+1 connected to the reference scan driving circuit GRD and the i-th initialization scan line GILi and an (i+1)th initialization scan line GILi+1 connected to the initialization scan driving circuit GID as a representative example. In addition, FIG. 7A shows pixels PXi1, PX(i+1)1, PXim, and PX(i+1)m connected to the first data line DL1 and the m-th data line DLm.

FIG. 7B shows the first write scan driving circuit GWD1 as a representative example of a scan driving circuit. The first write scan driving circuit GWD1 may include a plurality of stages ST1 to ST4 connected to each other. The stages ST1 to ST4 may be substantially the same, i.e., may have the same circuit configuration. FIG. 7B shows four stages ST1 to ST4 as a representative example, however, the first write scan driving circuit GWD1 may include stages respectively corresponding to the write scan lines GWL1 to GWLn shown in FIG. 5.

Each of first, second, third, and fourth stages ST1 to ST4 may include an input terminal IN, a first control terminal CT1, a second control terminal CT2, a carry terminal RT, and an output terminal OT. In addition, each of the stages ST1 to ST4 may further include first, second, and third voltage terminals VT1, VT2, and VT3.

The input terminal IN may receive a start signal FLM or a previous carry signal CR output from the carry terminal RT of one stage among previous stages. The start signal FLM may be input to the input terminal IN of the first stage ST1. The input terminal IN of the second stage ST2 may receive the carry signal CR output from the carry terminal RT of the first stage ST1.

Each of the stages ST1 to ST4 may receive first and second clock signals CLK1 and CLK2 respectively through first and second control terminals CT1 and CT2. Among the stages ST1 to ST4, the first control terminal CT1 of the odd-numbered stages ST1 and ST3 may receive the first clock signal CLK1, and the second control terminal CT2 of the odd-numbered stages ST1 and ST3 may receive the second clock signal CLK2. On the other hand, the first control terminal CT1 of the even-numbered stages ST2 and ST4 may receive the second clock signal CLK2, and the second control terminal CT2 of the even-numbered stages ST2 and ST4 may receive the first clock signal CLK1. The first clock signal CLK1 and the second clock signal CLK2 may have the same period and may have different phases. As an example, the second clock signal CLK2 may have a phase opposite to that of the first clock signal CLK1, i.e., a phase shift if 180° relative to the first clock signal.

The first voltage terminal VT1, the second voltage terminal VT2, and the third voltage terminal VT3 may receive a high voltage VGH, a first low voltage VGL1, and a second low voltage VGL2, respectively. Each of the high voltage VGH, the first low voltage VGL1, and the second low voltage VGL2 may have a direct current voltage level.

The high voltage VGH may be set as a high level of the scan signal, i.e., a gate-on voltage, and the first low voltage VGL1 may be set as a low level of the scan signal, i.e., a gate-off voltage. The second low voltage VGL2 may be a bias voltage having a level different from that of the first low voltage VGL1. The stages ST1 to ST4 may sequentially output the write scan signals to the write scan lines GWL1 to GWL4.

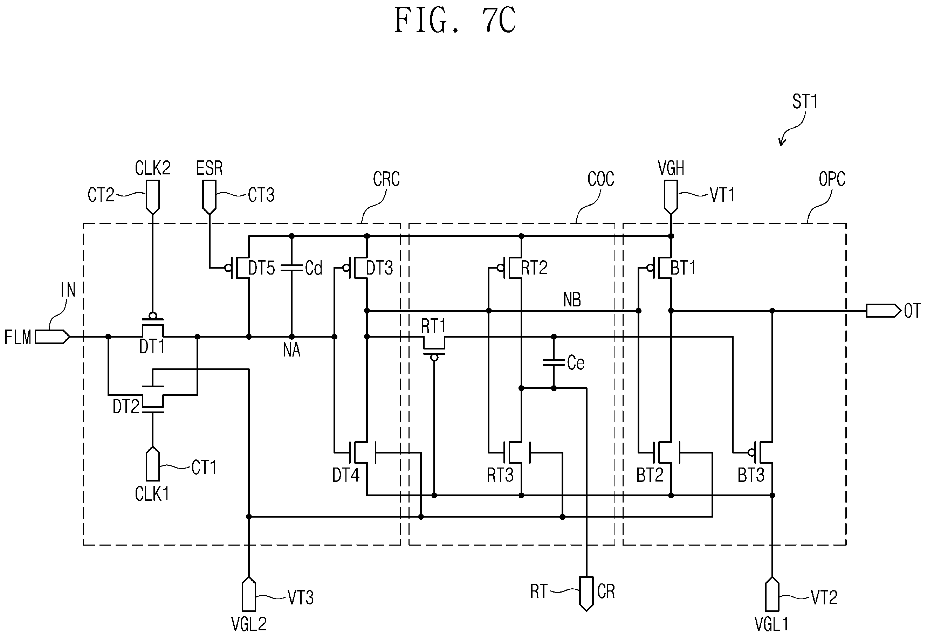

FIG. 7C is a circuit diagram of the first stage ST1 according to an embodiment of the present disclosure. Hereinafter, the circuit configuration of the first stage ST1 is described in detail. Since the stages ST1 to ST4 have substantially the same circuit configuration, descriptions on the circuit configuration of the other stages ST2 to ST4 are omitted below.

Referring to FIG. 7C, the first stage ST1 may include an output part OPC, a carry output part COC, and a control part CRC. The control part CRC may include first, second, third, fourth, and fifth control transistors DT1, DT2, DT3, DT4, and DT5 and a control capacitor Cd. The carry output part COC may include first, second, and third carry transistors RT1, RT2, and RT3 and a carry capacitor Ce. The output part OPC may include first, second, and third buffer transistors BT1, BT2, and BT3.

When the second clock signal CLK2 is at a low level, the first control transistor DT1 may be turned on. As the first control transistor DT1 is turned on, an electric potential of a first control node NA may depend on a voltage level of the start signal FLM. When the first clock signal CLK1 is at the high level, the second control transistor DT2 may be turned on. As the second control transistor DT2 is turned on, the electric potential of the first control node NA may depend on the voltage level of the start signal FLM. That is, since the first and second clock signals CLK1 and CLK2 have opposite phases to each other, the first and second control transistors DT1 and DT2 may be substantially simultaneously turned on, and the electric potential of the first control node NA may transition to the high level or the low level (depending on the start signal FLM) in the turned-on period of the first and second control transistors DT1 and DT2. On the contrary, when the second clock signal CLK2 is at the high level and the first clock signal CLK1 is at the low level, the first and second control transistors DT1 and DT2 may be substantially simultaneously turned off, and the electric potential of the first control node NA is disconnected from the start signal FLM during the turned-off period of the first and second control transistors DT1 and DT2.

When the electric potential of the first control node NA is at the high level, the third control transistor DT3 may be turned off, and the fourth control transistor DT4 may be turned on. Accordingly, the first low voltage VGL1 may be applied to a second control node NB through the turned-on fourth control transistor DT4. When the electric potential of the first control node NA is at the low level, the third control transistor DT3 may be turned on, and the fourth control transistor DT4 may be turned off. Accordingly, the high voltage VGH may be applied to the second control node NB through the turned-on third control transistor DT3.

When the high voltage VGH is applied to the second control node NB, the second carry transistor RT2 may be turned off, and the third carry transistor RT3 may be turned on. Accordingly, the carry terminal RT may receive the first low voltage VGL1 through the turned-on third carry transistor RT3, and the first low voltage VGL1 may be output as the carry signal CR applied to the input terminal IN of the next stage ST2 (refer to FIG. 7B). Meanwhile, when the first low voltage VGL1 is applied to the second control node NB, the third carry transistor RT3 may be turned off and the second carry transistor RT1 may be turned on. Accordingly, the carry terminal RT may receive the high voltage VGH through the turned-on first carry transistor RT1, and the high voltage VGH may output as the carry signal CR.

When the high voltage VGH is applied to the second control node NB, the first buffer transistor BT1 may be turned off and the second buffer transistor BT2 may be turned on. Accordingly, the output terminal OT may receive the first low voltage VGL1 through the turned-on second buffer transistor BT2, and the first low voltage VGL1 may be output as the first write scan signal GW1 (refer to FIG. 7B). Meanwhile, when the first low voltage VGL1 is applied to the second control node NB, the second buffer transistor BT2 may be turned off, and the first buffer transistor BT1 may be turned on. Accordingly, the output terminal OT may receive the high voltage VGH through the turned-on first buffer transistor BT1, and the high voltage VGH may be output as the first write scan signal GW1.

The control capacitor Cd may be connected between the first control node NA and the first voltage terminal VT1 to maintain the electric potential of the first control node NA. The first carry transistor RT1, the carry capacitor Ce, and the third buffer transistor BT3 may be configured to control voltage transitions at the carry terminal RT and the output terminal OT.

As an example, the control part CRC may further receive a power-on control signal ESR through the third control terminal CT3. The power-on control signal ESR may be activated in the display device DD (refer to FIG. 1) during a power-on period when a power is supplied to the display device DD (refer to FIG. 1). That is, the power-on control signal ESR may have the low level during the power-on period and then may have the high level during a normal driving period. Accordingly, the fifth control transistor DT5 may be turned on in response to the power-on control signal ESR at the low level. The high voltage VGH may be applied to the first control node NA through the turned-on fifth control transistor DT5 during the power-on period, and as a result, the second control node NB may be stably held at the first low voltage VGL1.

As an example, the first stage ST1 may include two types of transistors. As an example, the second buffer transistor BT2, the third carry transistor RT3, and the second and fourth control transistors DT2 and DT4 may include the first type transistor, and the first buffer transistor BT1, the first and second carry transistors RT1 and RT2, and the first, third, and fifth control transistors DT1, DT3, and DT5 may include the second type transistor. The first type transistor may be the N-type transistor, and the second type transistor may be the P-type transistor. The second buffer transistor BT2, the third carry transistor RT3, and the second and fourth control transistors DT2 and DT4 may be substantially the same type of transistor as the first to sixth pixel transistors T1 to T6 shown in FIG. 6A, and the first buffer transistor BT1, the first and second carry transistors RT1 and RT2, and the first, third, and fifth control transistors DT1, DT3, and DT5 may be a different type of transistor from the first to sixth pixel transistors T1 to T6. The first buffer transistor BT1, the first and second carry transistors RT1 and RT2, and the first, third, and fifth control transistors DT1, DT3, and DT5 may be substantially the same type of transistor as the fifth and sixth pixel transistors T5a and T6a shown in FIG. 6C.

Some transistors BT1, DT1, RT1, RT2, DT3, and DT5 among the transistors BT1, BT2, RT1 to RT3, and DT1 to DT5 included in the first stage ST1 shown in FIG. 7C may include a silicon semiconductor, e.g., a low temperature polysilicon (LTPS) semiconductor, and some transistors BT2, RT3, DT2, and DT4 may include an oxide semiconductor, however, the present disclosure is not limited thereto or thereby. Each of the transistors BT1, BT2, RT1, to RT3, and DT1 to DT5 included in the first stage ST1 may include the low temperature polysilicon (LTPS) semiconductor.

As described above, as at least one transistor among the transistors included in the gate driving circuit GDC (refer to FIG. 4) may be formed of the silicon semiconductor, e.g., the low temperature polysilicon (LTPS) semiconductor, a size of the non-display area DP-NDA (refer to FIG. 4) may be prevented from increasing.

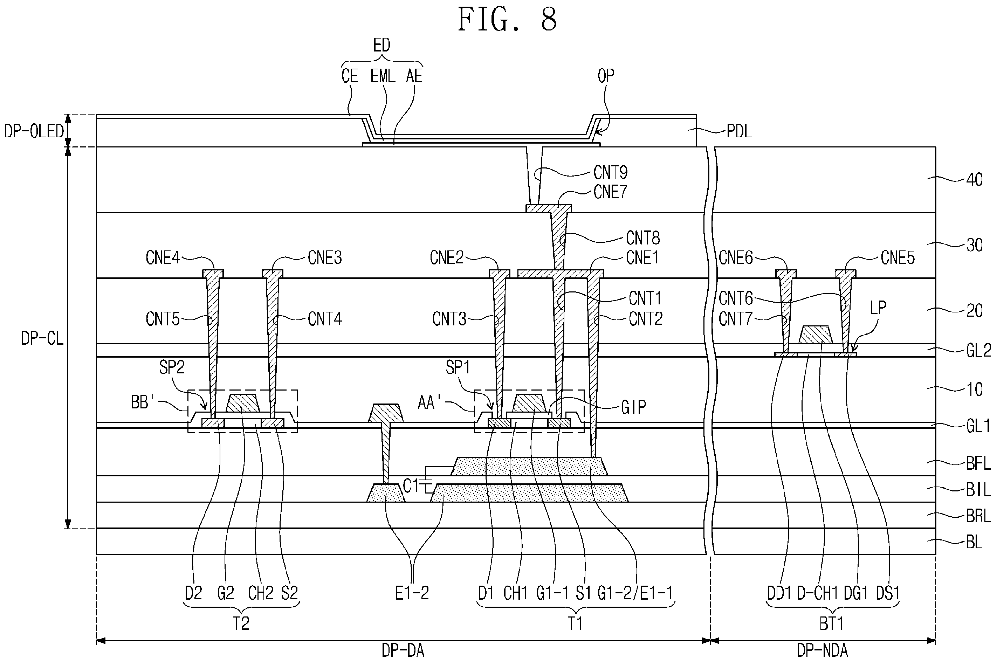

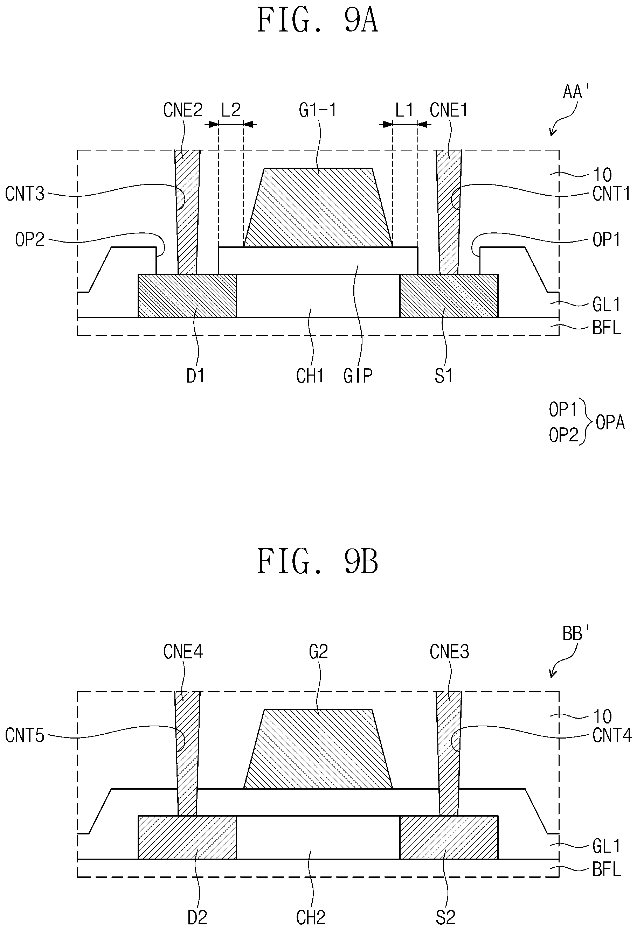

FIG. 8 is a cross-sectional view of the display panel according to an embodiment of the present disclosure. FIG. 9A is an enlarged cross-sectional view of a first area AA' shown in FIG. 8. FIG. 9B is an enlarged cross-sectional view of a second area BB' shown in FIG. 8.

Referring to FIG. 8, the display panel DP may include the base layer BL, the circuit element layer DP-CL disposed on the base layer BL, and the display element layer DP-OLED disposed on the circuit element layer DP-CL. The display panel DP may further include the encapsulation layer TFE as shown in FIG. 3. In addition, the display panel DP may further include functional layers such as an anti-reflective layer or a refractive index control layer. The circuit element layer DP-CL may include at least a plurality of insulating layers and a circuit element. The insulating layers described hereinafter may include an organic layer and/or an inorganic layer.

An insulating layer, a semiconductor layer, and a conductive layer may be formed by a coating or depositing process. Then, the insulating layer, the semiconductor layer, and the conductive layer may be selectively patterned through a photolithography process and an etching process. Accordingly, the semiconductor pattern, the conductive pattern, and the signal lines may be formed. Patterns disposed on the same layer may be formed through the same process.

The base layer BL may include a synthetic resin layer. The synthetic resin layer may include a heat-curable resin. The synthetic resin layer may include a polyimide-based resin, however, a material for the synthetic resin layer is not limited thereto. The synthetic resin layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. According to an embodiment, the base layer BL may include a glass substrate, a metal substrate, or an organic/inorganic composite material substrate. The base layer BL may include a first polyimide layer, a second polyimide layer, and an inorganic layer disposed between the first and second polyimide layers.

At least one inorganic layer may be disposed on an upper surface of the base layer BL. The inorganic layer may include at least one of aluminum oxide, titanium oxide, silicon oxide, silicon nitride, silicon oxynitride, zirconium oxide, and hafnium oxide. The inorganic layer may be formed in multiple layers. The inorganic layers may form a barrier layer BRL. The barrier layer BRL may prevent a foreign substance from entering the circuit element layer DP-CL. The barrier layer BRL may include a silicon oxide layer and a silicon nitride layer. According to an embodiment, multiple silicon oxide layers or silicon nitride layers may be provided, and the silicon oxide layers may be alternately stacked with the silicon nitride layers.

A conductive layer (hereinafter, referred to as a first conductive layer) may be disposed on the barrier layer BRL. The first conductive layer may include a plurality of first conductive patterns. FIG. 8 shows one first conductive pattern among the first conductive patterns. The first conductive pattern may define the second electrode E1-2 of the first capacitor C1.

A base insulating layer BIL may be disposed on the barrier layer BRL to cover the first conductive layer. The base insulating layer BIL may include one or more silicon oxide layers and one or more silicon nitride layers. According to an embodiment, the silicon oxide layers may be alternately stacked with the silicon nitride layers.

A conductive layer (hereinafter, referred to as a second conductive layer) may be disposed on the base insulating layer BIL. The second conductive layer may include a plurality of second conductive patterns. FIG. 8 shows one second conductive pattern among the second conductive patterns. The second conductive pattern may define the first lower gate G1-2 of the first pixel transistor T1. The first lower gate G1-2 of the first pixel transistor T1 may overlap or face the second electrode E1-2 of the first capacitor C1 with the base insulating layer BIL interposed therebetween. Accordingly, the first capacitor C1 may include the second electrode E1-2 and the first lower gate G1-2. The first lower gate G1-2 of the first pixel transistor T1 may further overlap the first upper gate G1-1 in the plan view.

The buffer layer BFL may be disposed on the base insulating layer BIL to cover the second conductive layer. The buffer layer BFL may increase an adhesion between the base insulating layer BIL and the semiconductor pattern or between the base insulating layer BIL and the conductive pattern. According to an embodiment, the buffer layer BFL may include one or more silicon oxide layers and one or more silicon nitride layers. The silicon oxide layers and the silicon nitride layers may be alternately stacked one on another.

A first semiconductor layer may be disposed on the buffer layer BFL in the display area DP-DA. The first semiconductor layer may include a plurality of oxide semiconductor patterns SP1 and SP2. In the present embodiment, each of the oxide semiconductor patterns SP1 and SP2 may include a crystalline or amorphous oxide semiconductor. As an example, each of the oxide semiconductor patterns SP1 and SP2 may include a metal oxide of metals, such as zinc (Zn), indium (In), gallium (Ga), tin (Sn), titanium (Ti), etc., or a mixture of the metal, such as zinc (Zn), indium (In), gallium (Ga), tin (Sn), titanium (Ti), etc., and oxides thereof. Each of the oxide semiconductor patterns SP1 and SP2 may include indium-tin oxide (ITO), indium-gallium-zinc oxide (IGZO), zinc oxide (ZnO), indium-zinc oxide (IZnO), zinc-indium oxide (ZIO), indium oxide (InO), titanium oxide (TiO), indium-zinc-tin oxide (IZTO), zinc-tin oxide (ZTO), or the like.

Each of the oxide semiconductor patterns SP1 and SP2 may include a plurality of regions distinguished from each other depending on whether the metal oxide is reduced or not. A region (hereinafter, referred to as a reduced region or a second region) where the metal oxide is reduced may have a conductivity higher than that of a region (hereinafter, referred to as a non-reduced region or a first region) where the metal oxide is not reduced. The reduced region may substantially act as a source region, a drain region, or a signal transmission region of a transistor. The non-reduced region may substantially correspond to a channel region (or a semiconductor region or a non-reduced region) of the transistor. In other words, a portion of the semiconductor pattern may be the channel region of a transistor, another portion of the semiconductor pattern may be the source region or the drain region of the transistor, and the other portion of the semiconductor pattern may be a signal transmission region.

The source region or the drain region may be the source or the drain of any of the pixel transistors T1 to T6 described with reference to FIG. 6A. The source or the drain of each of the pixel transistors T1 to T6 may include the source region or the drain region of the oxide semiconductor patterns SP1 or SP2 and the conductive pattern connected to the source region or the drain region of the oxide semiconductor patterns SP1 and SP2. Hereinafter, for the convenience of explanation, the source region or the drain region of the oxide semiconductor patterns SP1 and SP2 may be referred to as the source or the drain.

As shown in FIG. 8, the first pixel transistor T1 may include a first oxide semiconductor pattern SP1 including the first source S1, a first channel portion CH1, and the first drain D1. The first source S1 and the first drain D1 of the first pixel transistor T1 may extend in opposite directions from the first channel portion CH1. The second pixel transistor T2 may include a second oxide semiconductor pattern SP2 including the second source S2, a second channel portion CH2, and the second drain D2.

The first lower gate G1-2 may additionally function as a light blocking pattern. The first lower gate G1-2 may be disposed under the first channel portion CH1 of the first pixel transistor T1 to block a light incident thereto from the outside. The first lower gate G1-2 may prevent a voltage-current characteristic of the first pixel transistor T1 from varying due to the external light.

A first gate insulating layer (or a gate insulating layer) GL1 may be disposed on the oxide semiconductor patterns SP1 and SP2 to cover the oxide semiconductor patterns SP1 and SP2. The first gate insulating layer GL1 may be formed over the display area DP-DA and the non-display area DP-NDA. The first gate insulating layer GL1 may include an oxide. According to an embodiment, the first gate insulating layer GL1 may include a gate insulating pattern GIP disposed on the first oxide semiconductor pattern SP1. The gate insulating pattern GIP may overlap the first channel portion CH1 of the first oxide semiconductor pattern SP1. In addition, the gate insulating pattern GIP may overlap a portion of the first source S1 and a portion of the first drain D1.

The first capacitor C1 may occupy a large area in the pixel circuit PXC (refer to FIG. 6A). As the first capacitor C1 overlaps the first pixel transistor T1, an entire area of the pixel circuit PXC may be reduced. Accordingly, the integration of the pixel circuit PXC may be improved in the display panel to provide high-resolution.

A conductive layer (hereinafter, referred to as a third conductive layer) may be formed on the first gate insulating layer GL1. The third conductive layer may include the first upper gate G1-1 and the second upper gate G2, which are disposed on the first gate insulating layer GL1. As an example, the first upper gate G1-1 may be disposed on the gate insulating pattern GIP. As an example, the first upper gate G1-1 may be electrically connected to the first conductive pattern, i.e., the second electrode E1-2 of the first capacitor C1. In particular, the first upper gate G1-1 may be in contact with the second electrode E1-2 via a contact hole defined through the base insulating layer BIL, the buffer layer BFL, and the first gate insulating layer GL1.

The first gate insulating layer GL1 may include an oxide. As an example, the first gate insulating layer GL1 may have a thickness greater than about 100Å and equal to or smaller than about 1500Å. As an example, the first gate insulating layer GL1 may have a thickness of about 1400Å.

A first insulating layer 10 may be disposed on the buffer layer BFL to cover the first upper gate G1-1 and the second upper gate G2. The first insulating layer 10 may be an inorganic layer and/or an organic layer and may have a single-layer or multi-layer structure. The first insulating layer 10 may cover the first source S1 and the first drain D1 of the first pixel transistor T1 and the second source S2 and the second drain D2 of the second pixel transistor T2.

In the display area DP-DA, the first capacitor C1 may be disposed under the first pixel transistor T1 and may overlap the first pixel transistor T1. As an example, the first capacitor C1 may entirely overlap the first oxide semiconductor pattern SP1 of the first pixel transistor T1 in the plan view. The first electrode E1-1 of the first capacitor C1 may be formed integrally with the first lower gate G1-2 of the first pixel transistor T1.

In the non-display area DP-NDA, a second semiconductor layer may be disposed on the first insulating layer 10. The second semiconductor layer may include a plurality of silicon semiconductor patterns LP. Each of the silicon semiconductor patterns LP may include amorphous silicon or polycrystalline silicon. As an example, each of the silicon semiconductor patterns LP may include low temperature polysilicon (LTPS).

Each of the silicon semiconductor patterns LP may have different electrical properties depending on whether it is doped or not. Each of the silicon semiconductor patterns LP may include a conductive region having a relatively high conductivity and a channel region having a relatively low conductivity. The conductive region may be doped with an N-type dopant or a P-type dopant. A P-type transistor may include a doped region doped with the P-type dopant, and an N-type transistor may include a doped region doped with the N-type dopant. The channel region may be a non-doped region or a region doped at a lower doping concentration than the conductive region.

The conductive region may have a conductivity greater than that of the channel region and may substantially serve as an electrode or a signal line. In other words, a portion of each of the silicon semiconductor patterns LP may be the channel region of a transistor, and the other portion of each of the silicon semiconductor patterns LP may be a source region or a drain region of the transistor.

FIG. 8 shows the first buffer transistor BT1 from among the transistors included in the first stage ST1 (refer to FIG. 7C) as a representative example, and other transistors may have substantially the same structure as the first buffer transistor BT1. The first buffer transistor BT1 may include the silicon semiconductor pattern LP including a source DS1, a channel portion D-CH1, and a drain DD1. The source DS1 and the drain DD1 of the first buffer transistor BT1 may extend in opposite directions from the channel portion D-CH1.

A second gate insulating layer GL2 may be disposed on the first insulating layer 10 to cover the silicon semiconductor patterns LP. The second gate insulating layer GL2 may be formed over the entirety of the display area DP-DA and the non-display area DP-NDA without being patterned. As an example, the second gate insulating layer GL2 may have a thickness greater than zero (0) and equal to or smaller than about 1400Å. As an example, the second gate insulating layer GL2 may have a thickness of about 1350Å. As the thickness of the second gate insulating layer GL2 becomes thin, a driving performance of the transistors including the silicon semiconductor pattern LP, e.g., the first buffer transistor BT1, the first and second carry transistors RT1 and RT2, and the first, third, and fifth control transistors DT1, DT3, and DT5 shown in FIG. 7C, may be improved.

A conductive layer (hereinafter, referred to as a fourth conductive layer) may be disposed on the second gate insulating layer GL2. The fourth conductive layer may include a conductive pattern, i.e., a gate DG1, overlapping the channel portion D-CH1 of the first buffer transistor BT1.

A second insulating layer 20 may be disposed on the second gate insulating layer GL2 to cover the fourth conductive layer. In the present embodiment, the second insulating layer 20 may be an inorganic layer and/or an organic layer and may have a single-layer or multi-layer structure.

A conductive layer (hereinafter, referred to as a fifth conductive layer) may be disposed on the second insulating layer 20. The fifth conductive layer may include a plurality of connection electrodes. FIG. 8 shows first, second, third, fourth, fifth, and sixth connection electrodes CNE1, CNE2, CNE3, CNE4, CNE5, and CNE6 among the connection electrodes of the fifth conductive layer as a representative example. The first connection electrode CNE1 may be connected to the first source S1 via a first contact hole CNT1 (or a first-first contact hole) defined through the first insulating layer 10, the second gate insulating layer GL2, and the second insulating layer 20 and may be connected to the first lower gate G1-2 through a second contact hole CNT2 defined through the buffer layer BFL, the first gate insulating layer GL1, the first insulating layer 10, the second gate insulating layer GL2, and the second insulating layer 20. The second connection electrode CNE2 may be connected to the first drain D1 via a third contact hole CNT3 (or a first-second contact hole) defined through the first insulating layer 10, the second gate insulating layer GL2, and the second insulating layer 20.

The third connection electrode CNE3 may be connected to the second source S2 via a fourth contact hole CNT4 defined through the first gate insulating layer GL1, the first insulating layer 10, the second gate insulating layer GL2, and the second insulating layer 20, and the fourth connection electrode CNE4 may be connected to the second drain D2 via a fifth contact hole CNT5 defined through the first gate insulating layer GL1, the first insulating layer 10, the second gate insulating layer GL2, and the second insulating layer 20. The fifth connection electrode CNE5 may be connected to the source DS1 via a sixth contact hole CNT6 defined through the second gate insulating layer GL2 and the second insulating layer 20, and the sixth connection electrode CNE6 may be connected to the drain DD1 via a seventh contact hole CNT7 defined through the second gate insulating layer GL2 and the second insulating layer 20.

A third insulating layer 30 may be disposed on the second insulating layer 20 to cover the fifth conductive layer. In the present embodiment, the third insulating layer 30 may be an organic layer and may have a single-layer structure, but embodiments are not limited thereto or thereby.

A conductive layer (hereinafter, referred to as a sixth conductive layer) may be disposed on the third insulating layer 30. The sixth conductive layer may include a plurality of connection electrodes. FIG. 8 shows a seventh connection electrode CNE7 among the connection electrodes of the sixth conductive layer as a representative example. The seventh connection electrode CNE7 may be connected to the first connection electrode CNE1 via an eighth contact hole CNT8 defined through the third insulating layer 30.

A fourth insulating layer 40 may be disposed on the third insulating layer 30 to cover the sixth conductive layer. In the present embodiment, the fourth insulating layer 40 may be an organic layer and may have a single-layer structure, but embodiments are not limited thereto or thereby.

The first electrode AE of the light emitting element ED may be disposed on the fourth insulating layer 40. The first electrode AE may be an anode. The first electrode AE may be connected to the seventh connection electrode CNE7 via a contact hole CNT9 defined through the fourth insulating layer 40.

A pixel definition layer PDL may be on the fourth insulating layer 40. The pixel definition layer PDL may be provided with an opening OP defined therethrough to expose at least a portion of the first electrode AE. The opening OP of the pixel definition layer PDL may define a light emitting area. For instance, the pixels PX (refer to FIG. 4) may be arranged on the display panel DP (refer to FIG. 4) according to a specific rule. An area in which the pixels PX are arranged may be defined as a pixel area, and one pixel area may include the light emitting area and a non-light-emitting area adjacent to the light emitting area. The non-light-emitting area may surround the light emitting area.

A light emitting layer EML may be disposed on the first electrode AE. The light emitting layer EML may be disposed only in an area corresponding to the opening OP. The light emitting layer EML may be formed separately for each of the pixels PX.

In the present embodiment, the patterned light emitting layer EML is shown as a representative example, however, the light emitting layer EML may be commonly disposed over the pixels PX. The commonly-disposed light emitting layer EML may generate a white light or a blue light. In addition, the light emitting layer EML may have a multi-layer structure.

A second electrode CE may be disposed on the light emitting layer EML and the pixel definition layer PDL. The second electrode CE may be a common electrode that extends over all the pixels PX.

The encapsulation layer TFE (refer to FIG. 3) may be disposed on the second electrode CE. The encapsulation layer TFE may be commonly disposed over all the pixels PX. In the present embodiment, the encapsulation layer TFE may directly cover the second electrode CE. Alternatively, a capping layer may directly cover the second electrode CE, and in this case, the encapsulation layer TFE may be disposed on the capping layer.

The encapsulation layer TFE may include at least an inorganic layer or organic layer. According to an embodiment, the encapsulation layer TFE may include two inorganic layers and an organic layer disposed between the two inorganic layers. According to an embodiment, the encapsulation layer TFE may include a plurality of inorganic layers and a plurality of organic layers alternately stacked with the inorganic layers.

Referring to FIGS. 8 and 9A, an open area OPA may be defined through the first gate insulating layer GL1. According to an embodiment, the open area OPA may correspond to the first source S1 and the first drain D1 of the first pixel transistor T1. The first source S1 and the first drain D1 may be exposed to the outside through the open area OPA. The open area OPA may include a first opened portion OP1 corresponding to the first source S1 and a second opened portion OP2 corresponding to the first drain D1. The first source S1 may be exposed to the outside through the first opened portion OP1, and the first drain D1 may be exposed to the outside through the second opened portion OP2. The first opened portion OP1 may have substantially the same width as that of the second opened portion OP2, however, embodiments in accordance with the present disclosure are not limited thereto or thereby. According to an embodiment, the width of the first opened portion OP1 and the width of the second opened portion OP2 may be different from each other.

The gate insulating pattern GIP may be between the first opened portion OP1 and the second opened portion OP2. That is, the process of forming the first opened portion OP1 and the second opened portion OP2 may separate the gate insulating pattern GIP from the first gate insulating layer GL1 in the plan view. After the gate insulating pattern GIP is formed, the first insulating layer 10 may be formed, and the first contact hole CNT1 and the third contact hole CNT3 through the first insulating layer 10 may be formed. Accordingly, the first insulating layer 10 may be disposed in the first opened portion OP1 and the second opened portion OP2. The width of the first opened portion OP1 may be greater than the width of the first contact hole CNT1, and the width of the second opened portion OP2 may be greater than the width of the third contact hole CNT3.

Oxygen supplied after the first opened portion OP1 and the second opened portion OP2 are formed may move to the first oxide semiconductor pattern SP1. However, in a case where the first upper gate G1-1 is disposed on the first channel portion CH1, the first upper gate G1-1 may block the oxygen, and thus, the oxygen may not diffuse into the first channel portion CH1 through the upper gate G1-1. Accordingly, the oxygen supplied to the first channel portion CH1 may be less than the oxygen supplied to the first source S1 and the first drain D1. However, when the first source S1 and the first drain D1 of the first oxide semiconductor pattern SP1 are exposed through the first opened portion OP1 and the second opened portion OP2, respectively, oxygen may easily diffuse into the first channel portion CH1. Therefore, an ion concentration in the contact area of the first source S1 and the first drain D1 may be uniformly maintained, and thus, elemental characteristics or composition of the first pixel transistor T1 may be improved. As a result, screen characteristics and reliability of the display device DD (refer to FIG. 1) may be improved.

At least a portion of the gate insulating pattern GIP may be exposed after formation of the first upper gate G1-1. In the plan view, the portion of the gate insulating pattern GIP, which is exposed to the outside, may overlap a portion of the first source S1 and a portion of the first drain D1. A distance between the first upper gate G1-1 and the first opened portion OP1 may be referred to as a first distance L1, and a distance between the first upper gate G1-1 and the second opened portion OP2 may be referred to as a second distance L2. As an example, each of the first distance L1 and the second distance L2 may be equal to or greater than about 2µm and equal to or smaller than about 3µm. The portion of the gate insulating pattern GIP between the first upper gate G1-1 and the first source S1 may prevent the first upper gate G1-1 and the first source S1 from short-circuiting. In addition, the portion of the gate insulating pattern GIP between the first upper gate G1-1 and the first drain D1 may prevent the first upper gate G1-1 and the first drain D1 from short-circuiting.

Referring to FIGS. 8 and 9B, the gate insulating layer GL1 may not include an open area corresponding to the second source S2 and the second drain D2 of the second pixel transistor T2. Hydrogen may be supplied during the process of forming the first and second insulating layers 10 and 20. In particular, since the process of forming a silicon nitride layer maintains a high hydrogen partial pressure, a large amount of hydrogen may be supplied to the first oxide semiconductor pattern SP1 and the second oxide semiconductor patter SP2. Since hydrogen corresponds to a carrier, the hydrogen could reduce a resistance of the second source S2 and the second drain D2. The first gate insulating layer GL1, which lacks any open area near the second channel portion CH2, may block hydrogen from being diffused to the second channel portion CH2. Since hydrogen must diffuse a greater distance through the first gate insulating layer GL1 to reach the second channel portion CH2, the second channel portion CH2 may better maintain semiconductor characteristics compared to the second source S2 and the second drain D2.

A width of the fourth contact hole CNT4 and a width of the fifth contact hole CNT5 may be smaller than the width of the first opened portion OP1 and the width of the second opened portion OP2, respectively. Since the second pixel transistor T2 does not have an open area, the gate insulating pattern such as the gate insulating pattern GIP in the first pixel transistor T1 may not be formed in the second pixel transistor T2.

The area of each of the first source S1 and the first drain D1 of the first pixel transistor T1 is sacrificed to form the open area OPA. However, since the second source S2 and the second drain D2 of the second pixel transistor T2 does not require an open area, the entire area in the plan view of the pixel circuit PXC (refer to FIG. 6A) may be reduced. Accordingly, the integration of the pixel circuit PXC may be improved in the display device DD (refer to FIG. 1) to provide high-resolution.

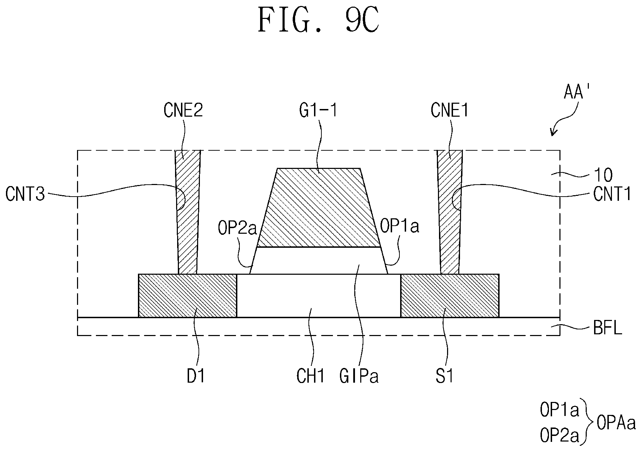

FIG. 9C is an enlarged view of a portion of a display panel according to an embodiment of the present disclosure.

Referring to FIG. 9C, an open area OPAa may be defined through a first gate insulating layer (refer to GL1 of FIG. 8). The open area OPAa may correspond to a first source S1 and a first drain D1 of a first pixel transistor T1. The open area OPAa may include a first opened portion OP1a corresponding to the first source S1 and a second opened portion OP2a corresponding to the first drain D1.

A gate insulating pattern GIPa may be etched using a first upper gate G1-1 as a mask, and as a result, the first upper gate G1-1 and the gate insulating pattern GIPa may have substantially the same shape in the plan view. That is, an edge of the first upper gate G1-1 may be aligned with an edge of the gate insulating pattern GIPa.

An edge of the first source S1 may be exposed through the first opened portion OP1a, and an edge of the first drain D1 may be exposed through the second opened portion OP2a. That is, a width of the first opened portion OP1a may be greater than the width of the first opened portion OP1 shown in FIG. 9A, and a width of the second opened portion OP2a may be greater than the width of the second opened portion OP2 shown in FIG. 9A.

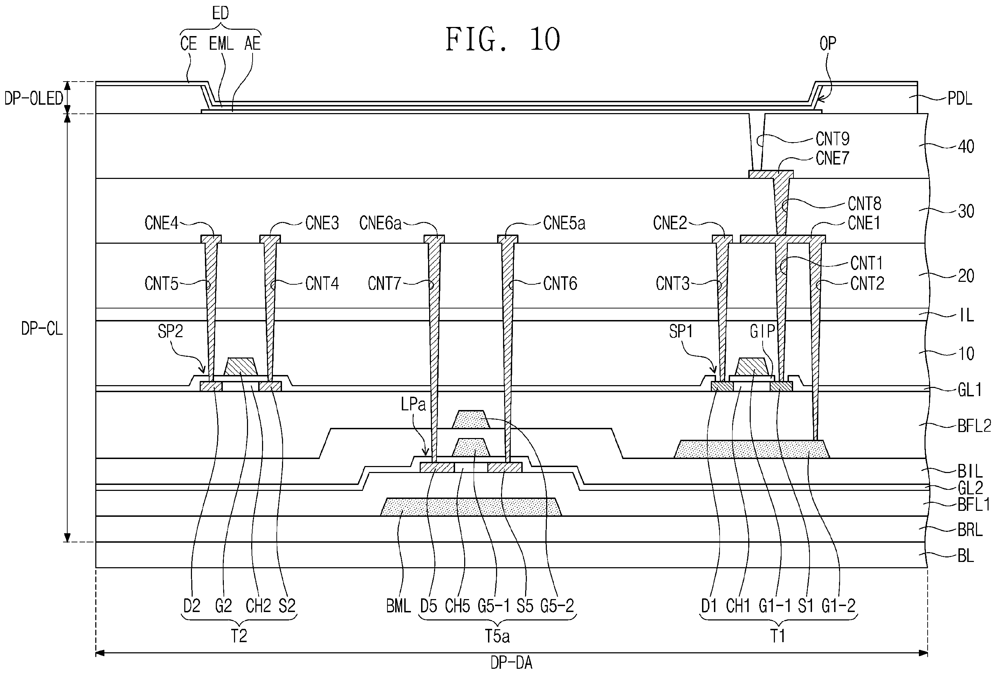

FIG. 10 is a cross-sectional view of a display panel according to an embodiment of the present disclosure. In FIG. 10, the same reference numerals denote the same elements as in FIG. 8, and thus, detailed descriptions of the same elements may be omitted below.

Referring to FIG. 10, a shielding electrode BML may be disposed on a barrier layer BRL. A first buffer layer BFL1 may be disposed on the barrier layer BRL to cover the shielding electrode BML. The first buffer layer BFL1 may have the same structure and the same function as those of the buffer layer BFL shown in FIG. 8. The first buffer layer BFL1 may include one or more silicon oxide layers and one or more silicon nitride layers. The silicon oxide layers may be alternately stacked with the silicon nitride layers.

In a display area DP-DA, a third semiconductor layer may be disposed on the first buffer layer BFL1. The third semiconductor layer may include a plurality of silicon semiconductor patterns LPa. Each of the silicon semiconductor patterns LPa may include amorphous silicon or polycrystalline silicon. As an example, each of the silicon semiconductor patterns LPa may include low temperature polysilicon (LTPS). In the plan view, the silicon semiconductor patterns LPa may overlap the shielding electrode BML. Accordingly, the shielding electrode BML may block a light from reaching the silicon semiconductor patterns LPa.

Each of the silicon semiconductor patterns LPa may have different electrical properties depending on whether the semiconductor pattern LPa is doped or not. Each of the silicon semiconductor patterns LPa may include a conductive region having a relatively high conductivity and a channel region having a relatively low conductivity. The conductive region may be doped with an N-type dopant or a P-type dopant. A P-type transistor may include a doped region doped with the P-type dopant, and an N-type transistor may include a doped region doped with the N-type dopant. The channel region may be a non-doped region or a region doped at a lower doping concentration than the conductive region.

FIG. 10 shows a fifth pixel transistor T5a among transistors shown in FIG. 6C as a representative example, and another transistor, e.g., the sixth pixel transistor T6a (refer to FIG. 6C), may have substantially the same structure as the fifth pixel transistor T5a. The fifth pixel transistor T5a may include the silicon semiconductor pattern LPa including a fifth source S5, a fifth channel portion CH5, and a fifth drain D5. The fifth source S5 and the fifth drain D5 of the fifth pixel transistor T5a may extend in opposite directions from the fifth channel portion CH5.

A second gate insulating layer GL2 may be disposed on the first buffer layer BFL1 to cover a third semiconductor layer. The second gate insulating layer GL2 may include an oxide. As an example, the second gate insulating layer GL2 may have a thickness greater than about 100Å and equal to or smaller than about 1400Å. As an example, the second gate insulating layer GL2 may have a thickness of about 1350Å.

A fifth-first upper gate G5-1 may be disposed on the second gate insulating layer GL2. The fifth-first upper gate G5-1 may be a component included in the first conductive layer described with reference to FIG. 8. A base insulating layer BIL may be disposed on the second gate insulating layer GL2. A fifth-second upper gate G5-2 may be disposed on an upper surface of the base insulating layer BIL. The fifth-second upper gate G5-2 may be a component included in the second conductive layer described with reference to FIG. 8. The fifth-second upper gate G5-2 may be disposed to overlap the fifth-first upper gate G5-1 in the plan view. According to an embodiment, the fifth-second upper gate G5-2 may be omitted. An inorganic insulating layer IL may be disposed on a first insulating layer 10. In the present disclosure, the inorganic insulating layer IL may be omitted.

A conductive layer (hereinafter, referred to as a fifth conductive layer) may be disposed on a second insulating layer 20. The fifth conductive layer may include a plurality of connection electrodes. A fifth connection electrode CNE5a of the fifth conductive layer may be connected to the fifth source S5 via a sixth contact hole CNT6 defined through the second gate insulating layer GL2, the base insulating layer BIL, a second buffer layer BFL2, a first gate insulating layer GL1, the first insulating layer 10, the inorganic insulating layer IL, and the second insulating layer 20. A sixth connection electrode CNE6a of the fifth conductive layer may be connected to the fifth drain D5 via a seventh contact hole CNT7 defined through the second gate insulating layer GL2, the base insulating layer BIL, the second buffer layer BFL2, the first gate insulating layer GL1, the first insulating layer 10, the inorganic insulating layer IL, and the second insulating layer 20.

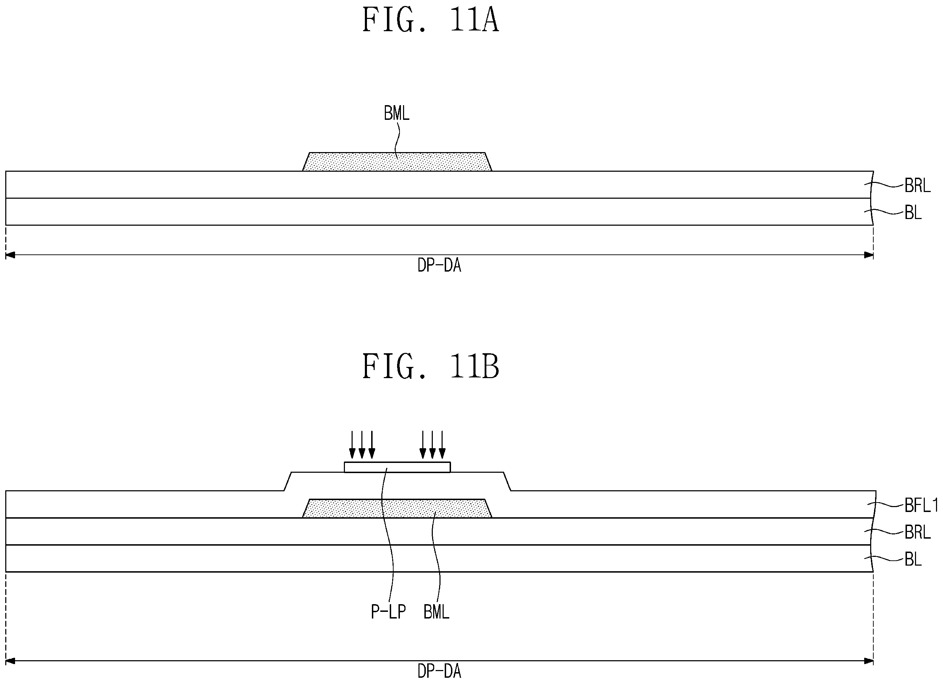

FIGS. 11A to 11I are cross-sectional views illustrating structures formed during a manufacturing process of a display device according to the embodiment of FIG. 10. FIGS. 11A to 11I use the same reference numerals to denote elements that are shown in FIGS. 8 to 10 and described above, and thus, detailed descriptions of these elements may be omitted below.

Referring to FIG. 11A, the barrier layer BRL may be formed on the base layer BL. In the present disclosure, the base layer BL and the barrier layer BRL may be referred to as a base substrate. The shielding electrode BML may be formed on an upper surface of the barrier layer BRL.

Referring to FIG. 11B, the first buffer layer BFL1 may be formed on the barrier layer BRL to cover the shielding electrode BML. The first buffer layer BFL1 may include one or more silicon oxide layers and one or more silicon nitride layers. The silicon oxide layers may be alternately stacked with the silicon nitride layers. A preliminary semiconductor pattern P-LP may be formed on the first buffer layer BFL1 and may overlap the shielding electrode BML.

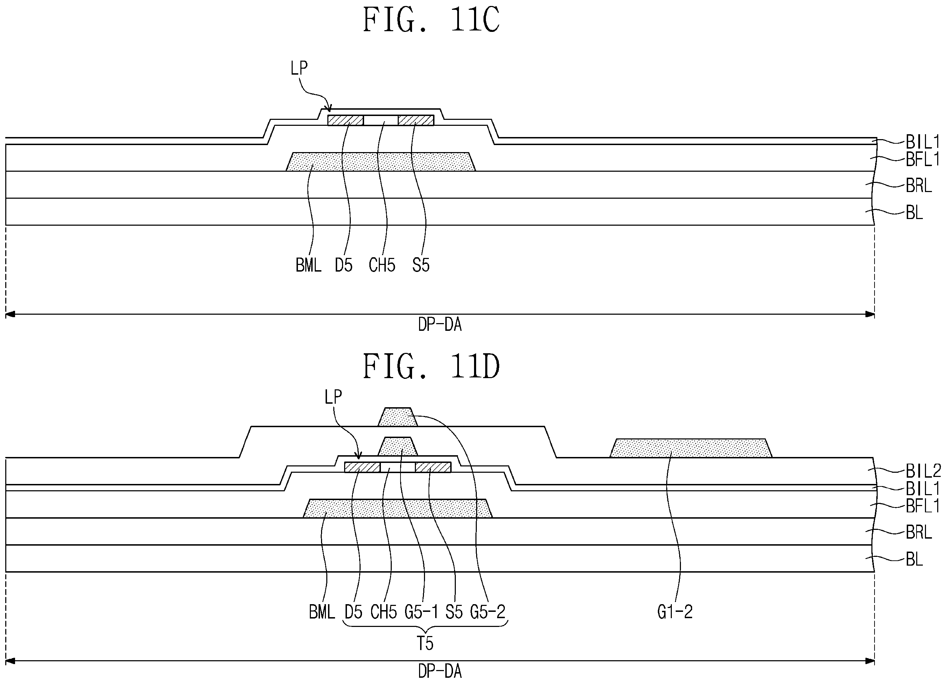

Referring to FIGS. 11B and 11C, subsequent processes performed on the preliminary semiconductor pattern P-LP may form the silicon semiconductor pattern LP. In detail, dopants may be provided to the preliminary semiconductor pattern P-LP. Although not shown in the drawings, a photoresist layer may be formed on the preliminary semiconductor pattern P-LP on an area corresponding to the fifth channel portion CH5, and the dopants may be provided to the exposed portions of the preliminary semiconductor pattern P-LP, to dope the exposed portions of the preliminary semiconductor pattern P-LP. That is, a doping process may provide the preliminary semiconductor pattern P-LP with doping needed for the silicon semiconductor pattern LP. The silicon semiconductor pattern LP may include the fifth source S5 and the fifth drain D5 that are doped with the dopants and the fifth channel portion CH5 that is not doped with the dopants.

Then, a first base insulating layer (or a gate insulating layer) BIL1 may be formed to cover the silicon semiconductor pattern LP. The first base insulating layer BIL1 may include one or more silicon oxide layers and one or more silicon nitride layers. The silicon oxide layers may be alternately stacked with the silicon nitride layers.

Referring to FIG. 11D, the first conductive layer may be formed on an upper surface of the first base insulating layer BIL1. That is, the fifth-first upper gate G5-1 may be formed on the upper surface of the first base insulating layer BIL1. Then, a second base insulating layer BIL2 may be formed to cover the fifth-first upper gate G5-1, and the second conductive layer may be formed on an upper surface of the second base insulating layer BIL2. The second conductive layer may include the fifth-second upper gate G5-2 and the first lower gate G1-2. Each of the fifth-second upper gate G5-2 and the first lower gate G1-2 may be defined as the second conductive pattern.

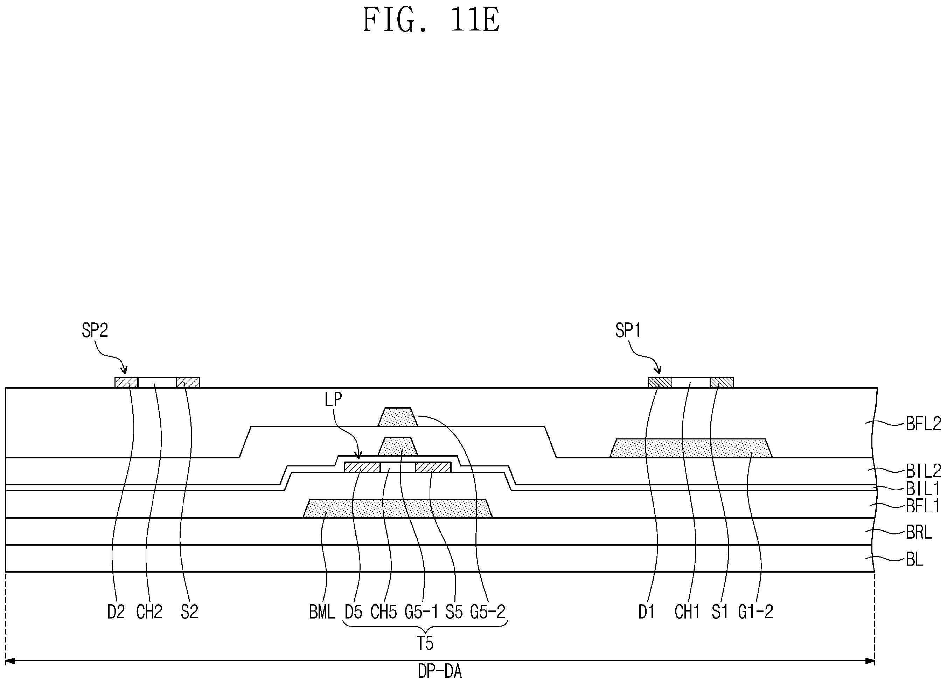

Referring to FIG. 11E, the first and second oxide semiconductor patterns SP1 and SP2 may be formed on the second buffer layer BFL2. A metal oxide layer may be formed on the second buffer layer BFL2 using a sputtering method or a metal organic chemical vapor deposition (MOCVD) method. In the forming of the metal oxide layer, a partial pressure of oxygen gas with respect to a reaction gas may be within a range of about 50% to about 100%. The reaction gas may further include silane gas, silane fluoride gas, nitrogen dioxide, etc. The metal oxide layer may be patterned to form the first and second oxide semiconductor patterns SP1 and SP2 on the second buffer layer BFL2.

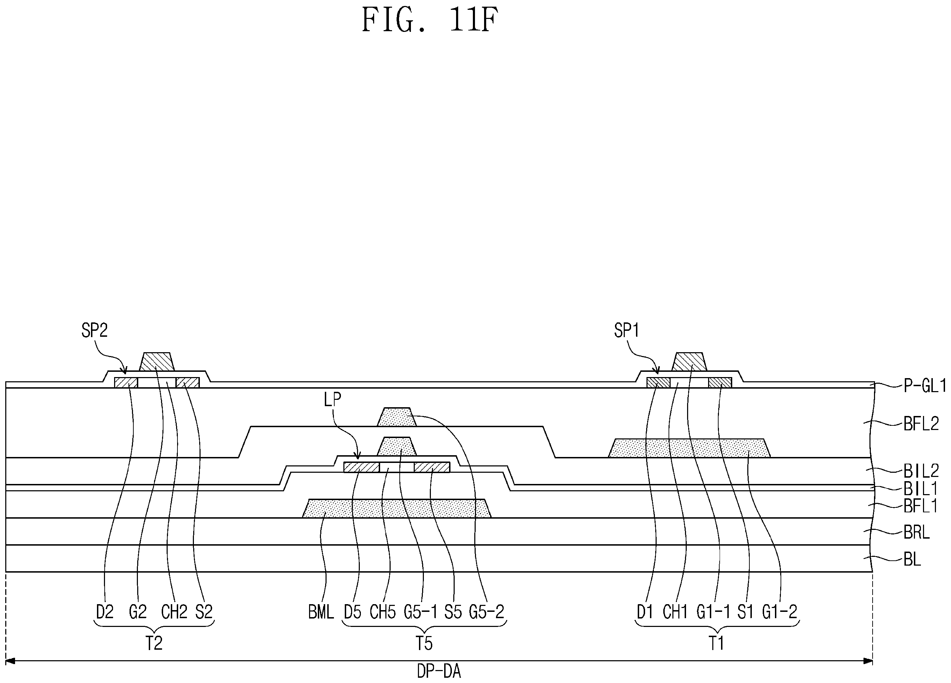

Referring to FIG. 11F, a first preliminary gate insulating layer P-GL1 may be formed to cover the first and second oxide semiconductor patterns SP1 and SP2. Then, a preliminary conductive layer may be disposed on the first preliminary gate insulating layer P-GL1. The preliminary conductive layer may include a metal material. The preliminary conductive layer may be a conductive layer used to form the first and second upper gates G1-1 and G2 of the first and second pixel transistors T1 and T2.

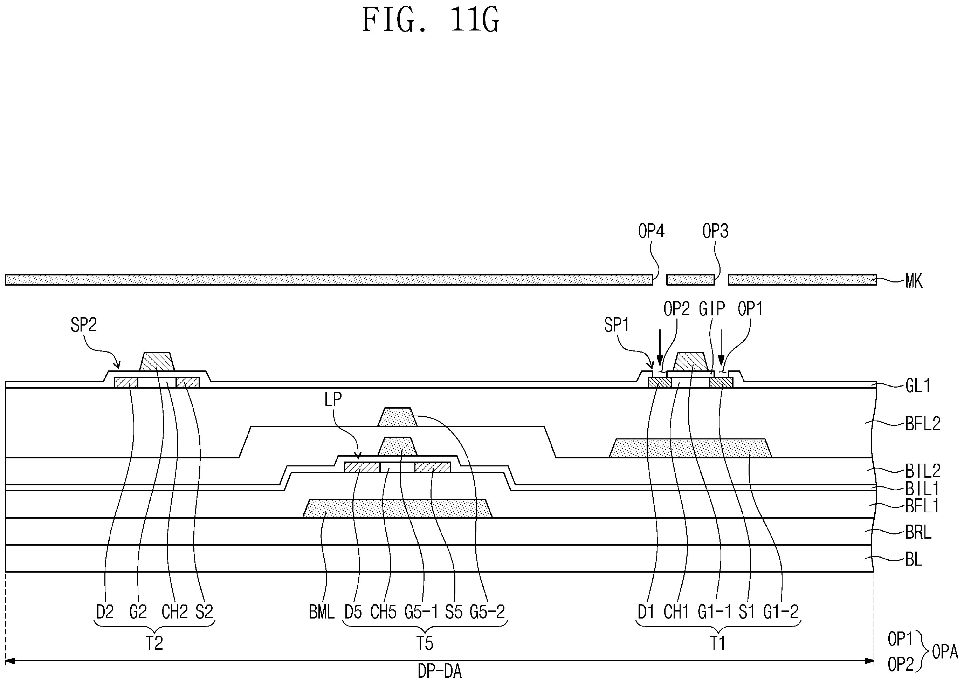

Referring to FIGS. 11F and 11G, the open area OPA may be defined through the first preliminary gate insulating layer P-GL1 to form the first gate insulating layer GL1. The open area OPA may include the first opened portion OP1 corresponding to the first source S1 and the second opened portion OP2 corresponding to the first drain D1. When the first preliminary gate insulating layer P-GL1 is patterned through a photolithography process and an etching process, the first opened portion OP1 and the second opened portion OP2 may be formed. As an example, a mask MK through which a third opened portion OP3 and a fourth opened portion OP4 are defined may be disposed above the first preliminary gate insulating layer P-GL1, and the first preliminary gate insulating layer P-GL1 may be selectively patterned to form the first opened portion OP1 and the second opened portion OP2. The first opened portion OP1 may overlap the third opened portion OP3, and the second opened portion OP2 may overlap the fourth opened portion OP4.

The first source S1 may be exposed to the outside through the first opened portion OP1, and the first drain D1 may be exposed to the outside through the second opened portion OP2. The oxygen supplied when the first opened portion OP1 and the second opened portion OP2 are formed may move to or diffuse into the first oxide semiconductor pattern SP1. When the first source S1 and the first drain D1 of the first oxide semiconductor pattern SP1 are exposed through the first opened portion OP1 and the second opened portion OP2, respectively, the oxygen may be easily diffused into the first channel portion CH1. Therefore, the ion concentration in the contact area of the first source S1 and the first drain D1 may be uniformly maintained, and thus, element characteristics of the first pixel transistor T1 may be improved. As a result, screen characteristics and reliability of the display device DD (refer to FIG. 1) may be improved.

An open area corresponding to the second source S2 and the second drain D2 of the second pixel transistor T2 may not be formed in the first preliminary gate insulating layer P-GL1. A large area may be required for the open area OPA corresponding to the first pixel transistor T1. However, as no open area corresponding to the second source S2 and the second drain D2 of the second pixel transistor T2 is used, so that the area of the second pixel transistor T2 and the entire area of the pixel circuit PXC (refer to FIG. 6A) may be smaller. Accordingly, the integration of the pixel circuit PXC may be improved in the display device DD (refer to FIG. 1), allowing the pixels PX to provide high-resolution images.

Then, the third conductive layer may be formed on the first gate insulating layer GL1. The third conductive layer may include the first upper gate G1-1 and the second upper gate G2. The first upper gate G1-1 may be disposed on the gate insulating pattern GIP.

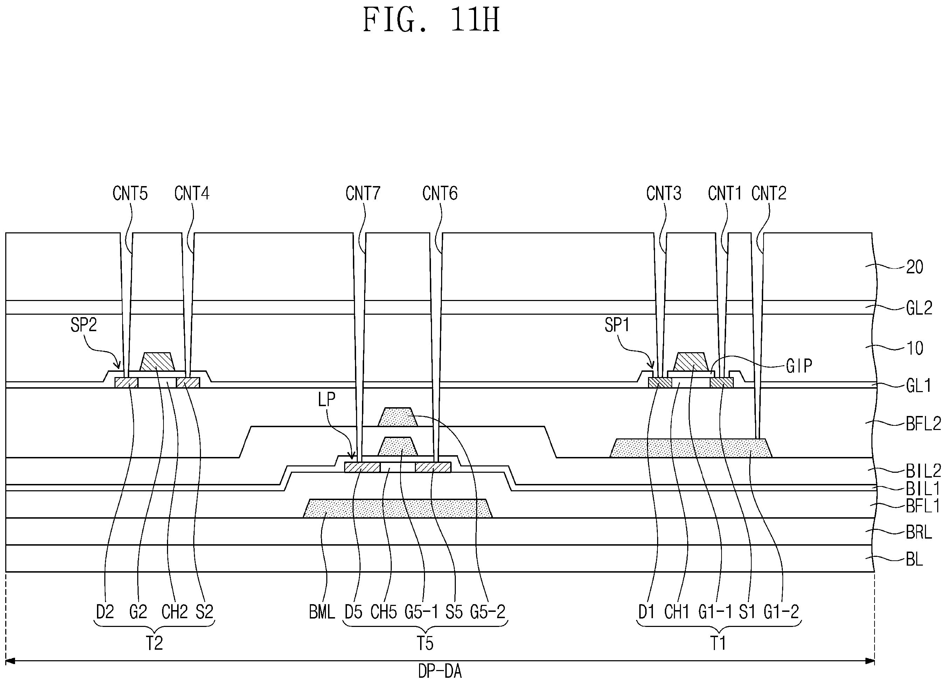

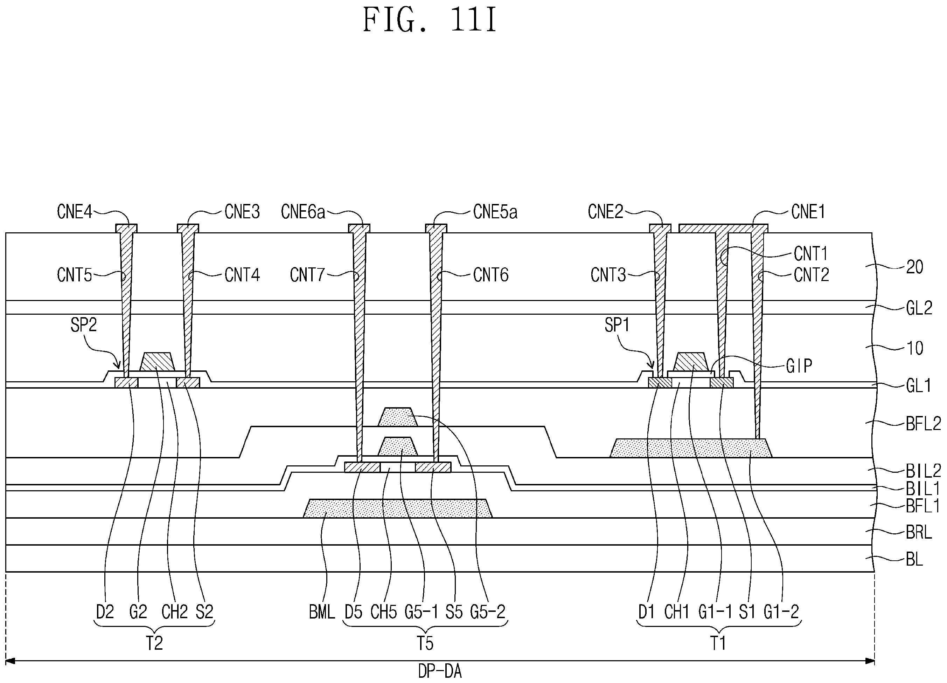

Referring to FIG. 11H, multiple insulating layers, for example, the first insulating layer 10, the second gate insulating layer GL2, and the second insulating layer 20, may be formed on the first gate insulating layer GL1. Then, the contact holes CNT1, CNT2, CNT3, CNT4, CNT5, CNT6, and CNT7 may be formed through the insulating layers. The contact holes CNT1, CNT2, CNT3, CNT4, CNT5, CNT6, and CNT7 may be formed through a via process. Referring to FIG. 11I, the preliminary conductive layer may be formed on the second insulating layer 20. The preliminary conductive layer may be patterned to form the connection electrodes.

Referring to FIGS. 11H and 11I, the first connection electrode CNE1 of the connection electrodes may be connected to the first source S1 via the first contact hole CNT1 defined through the first insulating layer 10, the second gate insulating layer GL2, and the second insulating layer 20 and may be connected to the first lower gate G1-2 via the second contact hole CNT2 defined through the second buffer layer BFL2, the first gate insulating layer GL1, the first insulating layer 10, the second gate insulating layer GL2, and the second insulating layer 20. The second connection electrode CNE2 may be connected to the first drain D1 via the third contact hole CNT3 defined through the first insulating layer 10, the second gate insulating layer GL2, and the second insulating layer 20.

The third connection electrode CNE3 may be connected to the second source S2 via the fourth contact hole CNT4 defined through the first gate insulating layer GL1, the first insulating layer 10, the second gate insulating layer GL2, and the second insulating layer 20, and the fourth connection electrode CNE4 may be connected to the second drain D2 via the fifth contact hole CNT5 defined through the first gate insulating layer GL1, the first insulating layer 10, the second gate insulating layer GL2, and the second insulating layer 20.

The fifth connection electrode CNE5a may be connected to the fifth source S5 via the sixth contact hole CNT6 defined through the first base insulating layer BIL1, the second base insulating layer BIL2, the second buffer layer BFL2, the first gate insulating layer GL1, the first insulating layer 10, the second gate insulating layer GL2, and the second insulating layer 20.

The sixth connection electrode CNE6a may be connected to the fifth drain D5 via the seventh contact hole CNT7 defined through the first base insulating layer BIL1, the second base insulating layer BIL2, the second buffer layer BFL2, the first gate insulating layer GL1, the first insulating layer 10, the second gate insulating layer GL2, and the second insulating layer 20.

Although example embodiments of the present disclosure have been described, the present disclosure is not limited to these embodiments, and various changes and modifications can be made by one ordinary skilled in the art within the scope of the present disclosure as hereinafter claimed in the appended claims.

Therefore, the disclosed subject matter should not be limited to any single embodiment described herein, and the scope of the present disclosure shall be determined according to the attached claims.

## Claims

1. A display device (DD) comprising:
a base layer (BL);
a pixel circuit (PXC) disposed on the base layer (BL) and comprising a plurality of pixel transistors (T1 to T6, T5a, T6a), wherein the plurality of pixel transistors (T1 to T6, T5a, T6a) include a first pixel transistor (T1) including a first oxide semiconductor pattern (SP1) and a second pixel transistor (T2) including a second oxide semiconductor pattern (SP2);
a gate insulating layer (GL1, GL2) covering the first oxide semiconductor pattern (SP1) and the second oxide semiconductor pattern (SP2); and
a light emitting element (ED) electrically connected to the pixel circuit (PXC),
wherein an open area (OPA, OPAa) is defined through the gate insulating layer (GL1, GL2) to correspond to a first source (S1) and a first drain (D1) of the first oxide semiconductor pattern (SP1).

2. The display device (DD) of claim 1, further comprising an insulating layer (10, 20) disposed on the gate insulating layer (GL1, GL2), wherein the insulating layer (10, 20) is provided with a first contact hole (CNT1 to CNT7) defined therethrough to a portion of the first source (S1) and a portion of the first drain (D1).

3. The display device (DD) of claim 2, wherein the first contact hole (CNT1 to CNT7) overlaps the open area (OPA, OPAa).

4. The display device (DD) of claim 2 or 3, further comprising:
a first connection electrode (CNE1, CNE3) disposed on the insulating layer (10, 20) and electrically connected to the first source (S1); and
a second connection electrode (CNE2, CNE4) disposed on the insulating layer (10, 20) and electrically connected to the first drain (D1).

5. The display device (DD) of claim 4, wherein the first contact hole (CNT1 to CNT7) comprises:
a first-first contact hole (CNT1, CNT4) through which the first source (S1, S2) is electrically connected to the first connection electrode (CNE1, CNE3); and
a first-second contact hole (CNT3, CNT5) through which the first drain (D1, D2) is electrically connected to the second connection electrode (CNE2, CNE4).

6. The display device (DD) of any one of claims 2 to 5, wherein the open area (OPA, OPAa) comprises:
a first opened portion (OP2, OP1a) corresponding to the first source (S1); and
a second opened portion (OP1, OP2a) corresponding to the first drain (D1).

7. The display device (DD) of claim 6, wherein the first opened portion (OP2) has a width greater than a width of the first-first contact hole (CNT1), and the second opened portion (OP1) has a width greater than a width of the first-second contact hole (CNT3).

8. The display device (DD) of claim 6 or 7, wherein a width of the first opened portion (OP2, OP1a) is equal to a width of the second opened portion (OP1, OP2a).

9. The display device (DD) of any one of claims 6 to 8, wherein an edge of the first source (S1) is exposed through the first opened portion (OP1a), and an edge of the first drain (D1) is exposed through the second opened portion (OP2a).

10. The display device (DD) of any one of claims 2 to 9, wherein the gate insulating layer (GL1, GL2) and the insulating layer (10, 20) are provided with a second contact hole (CNT4, CNT5) defined therethrough to a portion of a second source (S2) and a portion of a second drain (D2) of the second oxide semiconductor pattern (SP2).

11. The display device (DD) of claim 10, further comprising:
a third connection electrode (CNE3) disposed on the insulating layer (10, 20) and electrically connected to the second source (S2); and
a fourth connection electrode (CNE4) disposed on the insulating layer (10, 20) and electrically connected to the second drain (D2).

12. The display device (DD) of any one of the preceding claims, wherein each of the pixel transistors (T1 to T6, T5a, T6a) comprises an oxide semiconductor.

13. The display device (DD) of any one of the preceding claims, further comprising a gate driving circuit (GDC) disposed in a non-display area (DP-NDA) of the base layer (BL) and comprising a plurality of transistors (BT1, BT2, RT1 to RT3, DT1 to DT5), wherein at least one transistor (BT1, DT1, RT1, RT2, DT3, and DT5) among the plurality of transistors (BT1, BT2, RT1 to RT3, DT1 to DT5) comprises a silicon semiconductor.

14. The display device (DD) of claim 13, wherein each of the pixel transistors (T1 to T6, T5a, T6a) is an N-type transistor, and each of the plurality of transistors (BT1, BT2, RT1 to RT3, DT1 to DT5) is a P-type transistor.

15. The display device (DD) of any one of the preceding claims, wherein the pixel transistors (T1 to T6, T5a, T6a) further comprise a third pixel transistor (T5a), and the third pixel transistor (T5a) comprises a silicon semiconductor pattern (LPa).
